# EUROPEAN PATENT APPLICATION

(11) **EP 4 780 183 A1**
(43) Date of publication of application: **22.07.2026**
(21) Application number: 25152182.9
(22) Date of filing: 16.01.2025
(51) Int. Cl.: H10K 85/30, H10K 50/11, H10K 50/15

(54) **ELECTROLUMINESCENT DEVICE USING METAL ORGANIC COORDINATION COMPOUND**

(71) Applicant: beeOLED GmbH, 01217 Dresden (DE)
(72) Inventor: TKACHOV, Roman, 01159 Dresden (DE)
(74) Representative: Altmann Stößel Dick Patentanwälte PartG mbB

(57) **Abstract**

An organic electroluminescent device comprises a first electrode, a second electrode, and an organic layer disposed between the first electrode (104) and the second electrode (108), the organic layer (106) comprising at least one charge-neutral metal-organic coordination compound of general formula (1-1): 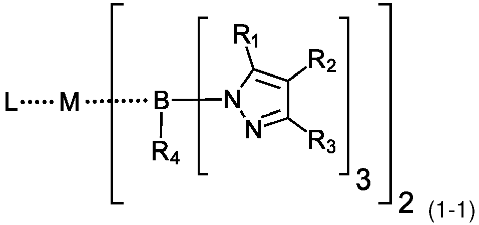 with
• M being Gd(III) or Ce(III),
• 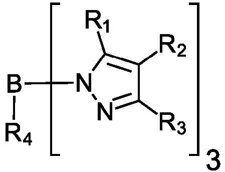 independently representing each a singly electrically negatively charged ligand with
• R₁ and R₃ being independently, preferably identical in each occurrence, selected from organyl groups having at least 6 atoms, and
• R₂ and R₄ being independently, preferably identical in each occurrence, selected from the group consisting of hydrogen, deuterium, fluorine, nitrile, and an organyl group, and with
• L representing a singly electrically negatively charged ligand, and
• broken lines indicating coordinative and/or ionic bonds.

## Description

### Technical Field

The invention concerns a metal-organic coordination compound and electroluminescent devices comprising the metal-organic coordination compound, wherein the coordination compound comprises substituted pyrazolyl-borate anions, and methods for synthesizing the coordination compounds, and methods for forming the electroluminescent devices in particular using thermal evaporation or sublimation.

### Background

Electroluminescent devices that make use of organic light emitting diodes (OLEDs) are state-of-the-art for flat panel display applications used in everyday consumer electronics. For OLEDs, a variety of materials are employed to fulfill specific functions within the device. For many such functions, such as charge transport, light generation, electrical doping, charge injection, it is desirable to use redox active metals. Those metals are always used in the form of metal-organic complexes to allow for good layer formation within the organic device. Various metals, such as d-metals, can form covalent bonds with suitable organic ligands. Yet, other interesting metals, such as lanthanides, cannot form covalent bonds, but instead form coordination compounds with coordinating ligands. Lanthanides can have many uses for application in electroluminescent devices, i.e. in OLED. Of specific interest is light emission, i.e. their use as emitter. Of the primary colors, red, green, and blue, most relevant for OLED design is the efficient generation of deep blue light as the other two primary colors may be generated by color conversion. Using well-shielded, intrametallic transitions, the lanthanide cations Tm(III), Eu(II), Yb(II), and Ce(lll) can be used for the design of blue emitting organic coordination compounds. Tm(lll) features an intrametallic f-f transition with long excited state lifetime, and as such is not very useful for OLED display application. The divalent lanthanides have poor ambient stability and are difficult to process. Most interesting for OLED display applications is Ce(lll) featuring an intrametallic d-f transition, which is typically emitting in the deep blue spectral region ideally suited for display applications. Between different orbitals, the excited state lifetime of this transition is sufficiently short. Different to all typical organic emitters with the singlet and triplet branching leading to poor efficiencies, the d-f transition of Ce(lll) is a doublet, which thus offers to harvest all electrical excitations within the OLED, yielding potentially highly efficient devices. On disadvantage of the Ce(lll) d-f transition is its relatively wide emission spectrum, which typically features two Gaussian emission peaks separated by some 60 nm. It is desirable to have a Ce(lll) coordination compound with a more narrow emission spectrum.

Given their very interesting combination of properties, coordination compounds using lanthanides, and specifically Ce(III), are very desirable for OLED application. To ensure stable device operation in consumer applications, such as displays, strong chemical bonds and high temperature stability are mandatory. The later, often quantified in terms of the glass transition temperature, is typically improved by using large, bulky organic fragments. The ligand binding strength is high, if the ligands is simultaneously electrostatically and coordinatively bound to the central metal, in other words, coordinating anions are preferred for complex design. In a related art, an archetypical coordinating anion often employed for OLED materials are pyrazolyl borate, which in combination with lanthanide cations has for example been disclosed in WO 98/55561 A1. Through one of the nitrogens present within the pyrazolyl fragment, this particular class of anions can form stable coordination bonds with the central metal cation. An important aspect of those pyrazolyl-borate type coordination compounds is whether the pyrazolyl is substituted, specifically substituted in 3 and 5 position of the H-pyrazole. In case the pyrazolyl is non-substituted, i.e. the 3 and 5 positions of the H-pyrazole are saturated with simple hydrogen (or Deuterium), then during coordination with a lanthanide cation preferably a homoleptic complex is formed having three identical borate type anions. On the other hand, if the 3 and 5 positions are substituted the anions become bulkier and often heteroleptic complexes with two borate type anion and a third auxiliary anion are formed. The third auxiliary ligand can for example be once more a substituted or non-substituted pyrazolyl or any other organic or inorganic anion. The homoleptic complexes of Ce(lll) are not emitting in the visible and as such are less interesting for use as emitting in OLED application. Of specific interest for OLED application are the heteroleptic complexes of Ce(lll) which do often show emission in the desired deep blue spectral region.

In WO 98/55561 A1 heteroleptic Ce(lll) complexes are disclosed for use as emitter in electroluminescent devices. Exemplified coordination compounds using methyl and trifluoromethyl substitutions in the 3,5-positions of all pyrazoles on the borate. Those bulky substituents result in the formation of heteroleptic complexes and in WO 98/55561 A1 inorganic triflate is exemplified as third auxiliary anion.

In CN 114057779, methyl is used in the 3- and 5-position of all pyrazoles of the borates and similar to the prior art WO98/55561 A1, they are combined into heteroleptic Ce(III) complexes for use as emitter in electroluminescent devices using triflate as third auxiliary anion. Additionally exemplified in CN114057779 are methyl and tri-fluormethyl pyrazolyl as auxiliary ligand for the heteroleptic complexes.

In CN 116082376, all pyrazolyls on the borate are methyl-substituted in 3- and 5-position and the auxiliary ligand is a 3,5-dimethyl pyrazolyl ligand too. Additionally, the auxiliary pyrazolyl is substituted in the 4-position with a bulky hole transporting group to achieve desirable hole transporting of the emitter. However, those very heavy and bulky compounds do not sublime anymore, and meaningful electroluminescent devices have not been disclosed in the art.

An object underlying the present invention is to provide electroluminescent compounds suitable for making deep blue electroluminescent devices suitable for consumer display applications. It is a particular objective to provide highly volatile deep blue emitting Cerium coordination compounds suitable for vacuum processing with high yield. It is a further objective that those Cerium emitting materials feature a narrow emission spectrum. It is a further objective that those Cerium coordination compounds are capable of transporting charge carriers, particularly holes.

The objectives are generally achieved using pyrazolyl type borates, which preferably are symmetrically or identically substituted in 3- and 5-position using substituents that are significantly bulkier as compared to methyl, i.e. having or consisting of 6 or more atoms in each instance. In combination with Ce(III), we surprisingly find that the use of more bulky substituents in 3- and 5-position as compared to conventional methyl still leads to the formation of deep blue emitting heteroleptic Cerium complexes, but with much improved, specifically narrower, i.e. more color pure, emission spectrum. Unexpectedly, those heavier derivatives of the known prior art are significantly more volatile, i.e. are better suited for making OLED devices by sublimation or evaporation, which is the standard in the display industry. Most surprising and unexpectedly, replacement of methyl by more bulky side groups turns the previously non-charge transporting complex into a hole transporting derivative, which greatly simplifies the integration of the emitter into OLED devices, and for example allows for the design of single material emission layers, comprising only the emitting material. Within this disclosure the features of the inventive materials will be carefully compared to the closest prior art materials using in each case the same environment, demonstrating the most unusual change in performance by seemingly minor chemical modification. This unusual combination of high volatility, deep blue and efficient light generation with narrow emission spectrum, and the ability of transporting holes makes such lanthanide coordination compounds using specifically substituted pyrazolyl borate anions highly useful for the application in blue electroluminescent devices suitable for display applications.

The objectives are achieved according to the present invention by an organic electroluminescent device comprising:
a first electrode,
a second electrode, and
an organic layer disposed between the first electrode and the second electrode,
the organic layer comprising at least one charge-neutral metal-organic coordination compound of general formula (1-1): 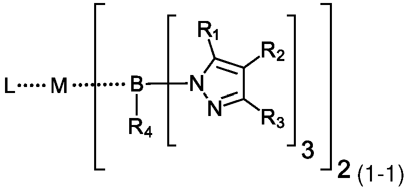 with
   - M being Gd(III) or Ce(III),
   - 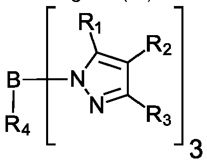 independently representing each a singly electrically negatively charged ligand with
   - R₁ and R₃ being independently, preferably identical in each occurrence, selected from organyl groups having at least 6 atoms, and
   - R₂ and R₄ being independently, preferably identical in each occurrence, selected from the group consisting of hydrogen, deuterium, fluorine, nitrile, and an organyl group, and with
   - L representing a singly electrically negatively charged ligand, and
   - broken lines indicating coordinative and/or ionic bonds.

The objectives are achieved specifically for **R₁** and **R₃** in each instance being a, preferably identical, substituted or non-substituted aryl, preferably phenyl, or substituted or non-substituted heteroalkyl, or substituted or non-substituted alkyl, preferably ethyl, most preferably **R₁** and **R₃** are ethyl; and for
**R₄** being hydrogen, deuterium, fluorine, nitrile, a linear or branched heteroalkyl or a linear or branched alkyl, preferably selected from methyl, ethyl, iso-propyl, n-propyl or n-butyl or for **R₄** being a substituted or non-substituted aryl or substituted or non-substituted heteroaryl, preferably selected from phenyl, pyridyl, pyrazolyl, triazoyl, or imidazoyl; and for
**R₂** being hydrogen, deuterium, or methyl, ethyl, propyl; and for
**L** being a substituted or non-substituted heterocycle, preferably the heterocycle being selected from imidazolyl, pyrazolyl, 1 ,2,3-triazolyl, 1 ,2,4-triazoyl, and benzimidazolyl, with optional substituents preferably being selected from methyl, ethyl, isopropyl, n-propyl, tert-butyl, isobutyl, n-butyl, phenyl, and mesityl. Most preferred L is a pyrazolyl that is disubstituted in 3,5 positions with both substituents being identical; and for
**L** being specifically a pyrazolyl with identical substitution pattern as used in formula (1-1), i.e. by using a metal-organic coordination compound derived from the generic formula (1-2): 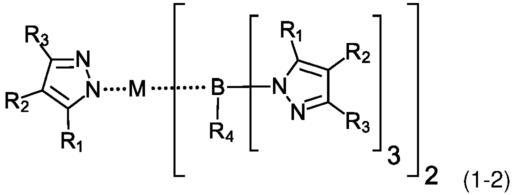
with 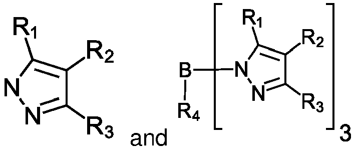 independently representing each a singly electrically negatively charged ligand, with R₁ to R₄ being independently, preferably identical in each occurrence, as defined above, the broken lines and M being as defined above.

The objectives can specifically be achieved by using any of the compounds G1 to G18 in the electroluminescent device according to the invention:

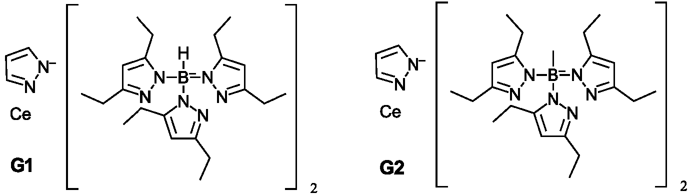

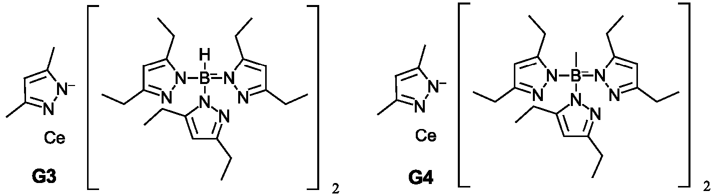

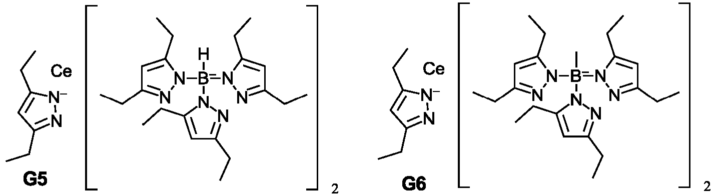

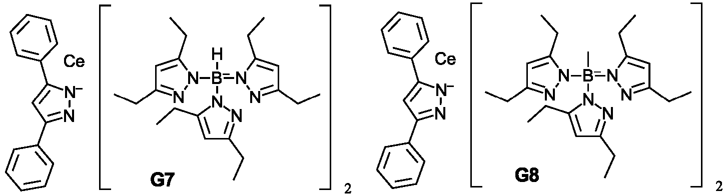

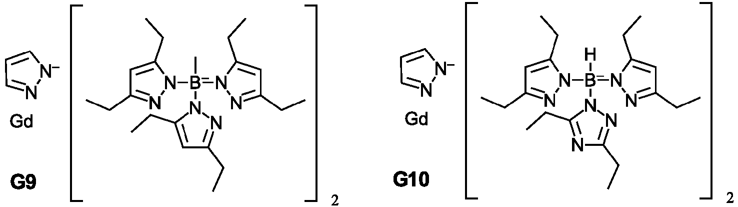

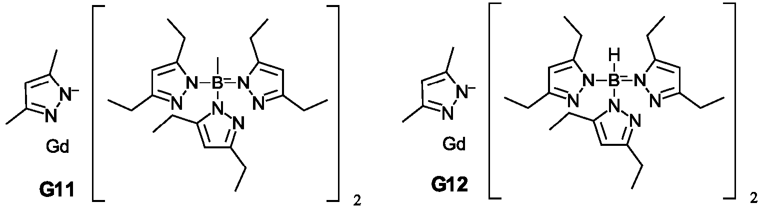

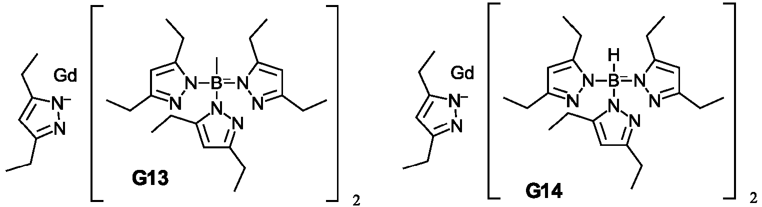

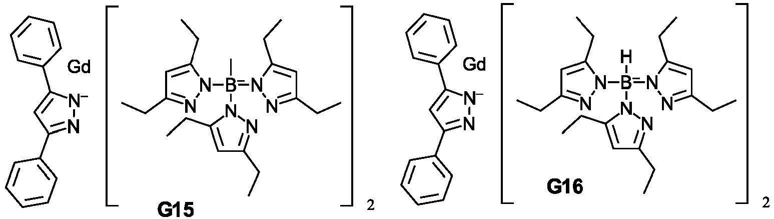

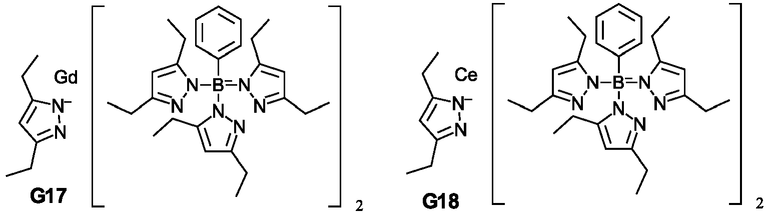

The objective is further achieved by an organic layer that comprises the metal organic coordination compound according to formula (1-1) and further comprises at least one phosphorescent emitting material. Preferably the phosphorescent emitting material emits substantially in the blue spectral region, and/or comprises a metal cation selected from Pt(II) or Ir(III) and/or further comprises at least one fluorescent, hyperfluorescent, or TADF-type emitting organic material. In particular, the fluorescent material can comprise one or more six-membered heteroaryl or heteralkyl rings comprising one or more boron atoms in combination with (nitrogen and/or oxygen) atoms as part of the ring.

The objective is specifically achieved by organic layers comprising the metal organic coordination compound according to formula (1-1) being configured as hole transporting layer. The hole transporting layer can be adjacent to any of the electrodes, preferably the anode, or can be a layer not in contact with any of the electrodes, for example as part of a charge generation layer. The hole transport layer can substantially only comprise the metal organic coordination compound but can as well be mixed with one or more additional materials, for example at least one redox dopant capable of generating free holes.

The objective is further achieved by a process for preparing those electroluminescent devices wherein any of the metal organic coordination compounds described above are deposited from gas phase, preferably using an evaporation and/or sublimation and/or carrier gas process, or by deposition from solution.

The present invention relates to the use of specific substituted pyrazolyl-borate anions to design metal organic coordination compounds. The borate anions can be very volatile even without using any fluorination or fluorinated side groups. As such the coordination compounds can as well show high volatility making them suitable for evaporation or sublimation processing and various examples are presented in this invention. For electroluminescent devices, of specific interest are blue emitters, for example derived from the doublet optical transition of Ce(III). In this context the borate anions according to the invention can have sufficient high triplet energy to allow for the generation of deep blue emission and various highly efficient electroluminescent devices are demonstrated within this invention. The emission spectrum is relatively narrow in comparison to other Cerium emitters. Further the Cerium compounds according to the invention can show charge transporting characteristics allowing for the design of electroluminescent devices with only a pure (unmixed) emission layer, or generally where the emitting material according to the invention has two functions, namely charge transport and emission, thereby reducing the number of materials needed to design the electroluminescent device. Finally, the synthesis purification of the substituted pyrazolyl anions is specifically eased by their superior solubility as compared to less substituted comparative structures. Therefore, producing the compounds in large scale and purity for mass production is very straightforward and many concrete examples are presented as part of this disclosure including purification methods.

The combination of the properties mentioned enables the design of very efficient deep blue emitting OLED devices with high operational stability. As such, the metal-organic coordination compounds according to the invention are ideally suited as active emitting materials in electroluminescent consumer electronics applications.

### Summary of the invention

In various aspects of this invention, metal-organic coordination compounds coordinated by two substituted pyrazolyl borate anions, methods for synthesizing and purifying those compounds as well as electroluminescent devices containing the same are provided. Those complexes can show a high volatility and good solubility, which eases their purification. They can show an improved narrower emission spectrum and much improved charge carrier transport capability compared to less substituted derivatives.

The objective is achieved by an electroluminescent device comprising a coordination compound comprising two substituted pyrazolyl borate anions as defined above and in claim 1. The borate anion has four covalent bonds to individual atoms or organyl groups making it a singly electrically negatively charged anion. Any negatively charged anion naturally does form an electrostatic bond with any (positively charged) central metal cation. The specifically substituted H-pyrazole group used in the borates according to the invention provides for additional coordination bonds by means of a nitrogen atom that can coordinate towards the central metal cation, while the second nitrogen forms the covalent bond with the boron. This is particularly important if the central metal does not from any covalent bonds with anionic or neutral ligands, as is the case with lanthanides. Therefore, these borate type ligands, also known as "scorpionates" have a specific advantage to form stable metal organic coordination compounds with lanthanides. Of specific interest for OLED applications are emitting lanthanides based on the lowest electronically excited intrametallic transition of Cerium 3+, which offers short excited state lifetimes suitable for high excitation densities as required for high brightness in display applications. Further this particular d-f transition is indifferent to excitation of singlet or triplet spin electron-hole pairs and can thus offer high light generation efficiencies in OLED devices. The natural emission of Ce3+ is in the near UV spectral region, not directly suitable for applications requiring visible light. As often described in literature and prior art, this transition is easily shifted towards the visible using electron rich organic ligands. For example, the homoleptic complex formed by Ce3+ in combination with three identical pyrazolyl-borate anions emits at 412 nm, at the deep blue end of the visible spectrum. Homoleptic complexes with pyrazolyl-borate anions in combination with a lanthanide cation of oxidation stage 3+ are formed only if the 3-and 5-position of the pyrazole groups are either unsubstituted or substituted by a single atom. Preferred for OLED applications are complexes using pyrazolyls substituted in 3- and 5-positions with more than one atom such as with methyl groups. For those bulkier anions the coordination sphere is too crowded to allow for three borate type anions. Instead, heteroleptic complexes form with two borate anions and one less bulky auxiliary ligand. Depending on the exact nature of the auxiliary ligand, and specifically for electron rich ones, the substantially intrametallic d-f transition of the central Ce³⁺ may be further shifted towards longer wavelengths. In many cases the desired emission for OLED display applications around 455 nm can be achieved, and various examples are shown in this disclosure. We made a series of coordination compounds using substituents in 3- and 5-position of pyrazole that are even more bulky than methyl, specifically having more than 6 atoms. Similar to methyl substitutions, heteroleptic complexes form, which will be unequivocally demonstrated in this disclosure. Surprisingly, many properties of this compounds change to the better by this seemingly minor modification. The solubility can be substantially improved easing synthesis and purification. As well and although the molecular weight of the complex increases, the volatility can be substantially improved, allowing for processing or purifying of the compounds by sublimation. Unexpectedly, the emission spectrum becomes narrower; corresponding OLED devices emit more color pure light. Surprisingly, the derivatives having substituents that are bulkier than methyl can become hole transporting, which, besides other, allows for the design of a single material emission layer within the electroluminescent device.

In various preferred embodiments the substitutions in 3- and 5-positions, **R₁** and **R₃** in formula (1-1), are in each instance (12 times) a substituted or non-substituted aryl, preferably phenyl, or a substituted or non-substituted heteroalkyl, or a substituted or non-substituted alkyl, preferably ethyl. Most preferably all groups **R₁** and **R₃** are ethyl. Those particular substituents according to the invention are bulkier as compared to methyl to allow for the positive effects described above. At the same time those substituents, such as phenyl or ethyl, do not increase the molecular weight too much such that a high volatility can be maintained.

In various preferred embodiments the fourth organyl group that is covalently linked to the borate, **R₄,** in formula (1-1) is selected from hydrogen, deuterium, fluorine, nitrile, a linear or branched heteroalkyl or a linear or branched alkyl, and preferably selected from methyl, ethyl, iso-propyl, propyl or n-butyl or with **R₄** being a substituted or non-substituted aryl or a substituted or non-substituted heteroaryl, and preferably selected from phenyl, pyridyl, pyrazolyl, triazoyl, and imidazoyl. These preferred atoms or organyl groups do form stable covalent bonds with the central metal cation, while not adding too much molecular weight to maintain high volatility. This forth organyl group, or atom may for sterical reasons not coordinate towards the central metal cation, therefore embodiments using aryl or alkyl groups without any heteroatoms are indeed feasible.

In various preferred embodiments the third substitution position on the pyrazolyl, labeled **R₂** in formula (1-1), is selected from hydrogen, deuterium, methyl, ethyl, or propyl. The substitution pattern in this position is not decisive on whether homo- or heteroleptic complexes are formed with lanthanides in oxidation stage 3+. Those preferred substitutions can offer improved thermal stability without adding too much molecular weight, thereby maintaining a high volatility. Those preferred non-aromatic substituents as well maintain a high intraligand triplet energy of the pyrazole, thereby maintaining a pure intrametallic d-f transition for compounds with Ce3+ central metal cation.

To achieve a desired emission color in the blue spectral region in combination with a cerium 3+ cation, the auxiliary ligand, labeled **L** in formula (1-1), can be electron rich comprising for example nitrogen or sulfur. To achieve high operational stability in electroluminescent devices this auxiliary ligand can preferably coordinate to the central metal cation and is preferably a heterocyclus. Preferably only small, preferably non-conjugating, substituents can be present on the preferably heterocyclic ligand that improve the operational stability but at the same time maintain a high intraligand triplet energy to preserve a potential Ce3+ d-f intrametallic transition on the central metal cation. Therefore, in various preferred embodiments the auxiliary anionic ligand, **L** in formula (1-1) is a substituted or non-substituted heterocycle, preferably the heterocycle is selected from imidazolyl, pyrazolyl, 1 ,2,3-triazolyl, 1 ,2,4-triazoyl, and benzimidazolyl. With optional substituents preferably selected from methyl, ethyl, isopropyl, n-propyl, tert-butyl, isobutyl, n-butyl, phenyl, and mesityl. Most preferred L is a pyrazolyl that is disubstituted in 3,5-positions with both substituents being identical.

In various embodiments the auxiliary ligands, L in formula (1-1) is pyrazolyl with an identical substitution pattern as present in the pyrazolyl borates according to formula (1-1); that is the H-pyrazole is at least identically substituted in 3- and 5-positions with substituents having 6 or more atoms and formula (1-1) can thus be specified as formula (1-2) with **R₁** to **R₄,** the broken lines, and **M** being defined as above:

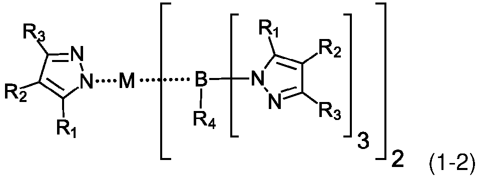

With the same or identical pyrazolyl used as auxiliary ligand and as part of the borate, isomerism can be prevented which can give rise to higher thermal stability and generally eases the synthesis and purification.

In various embodiments electroluminescent devices comprise one or more metal organic coordination compound selected from G1 to G18. Within those embodiments, the preferred substitution for **R₁** and **R₃ ,** namely ethyl, is used. All compounds feature pyrazole as preferred auxiliary ligand, **L,** thereby ensuring excellent emission characteristics for Ce³⁺ complexes in the deep blue spectral region. For compounds G5, G6, G13, G14, G17, G18 the substitution pattern on the auxiliary ligand is identical to the one used in the borates: it is in each instance ethyl. In all those embodiments the fourth organyl group, R₄ in formula (1-1) is either non-substituted, such as in G1, or it is a small aliphatic or aromatic group such as methyl or phenyl in G2 and G17, respectively and all compounds exhibit high volatility.

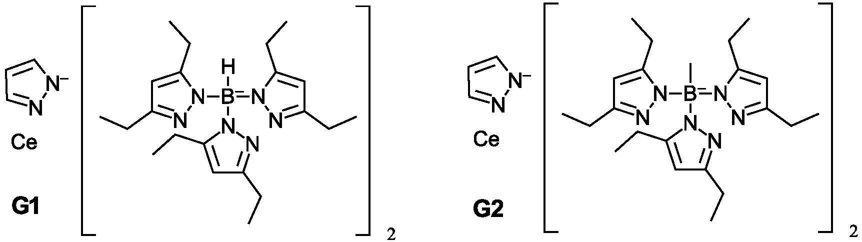

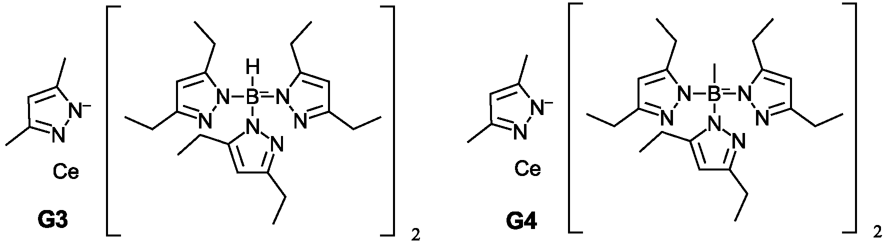

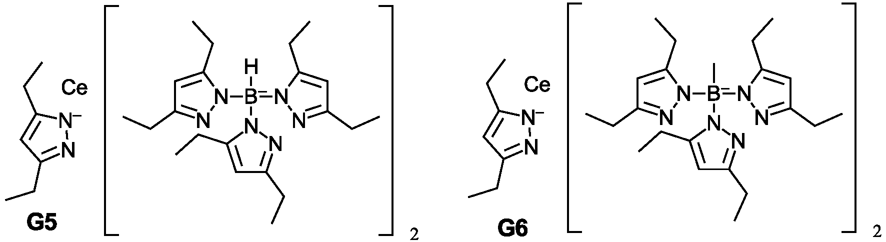

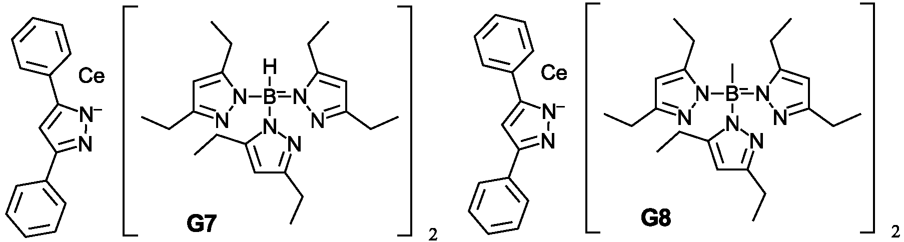

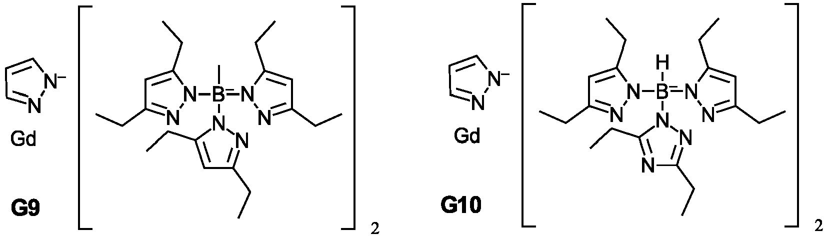

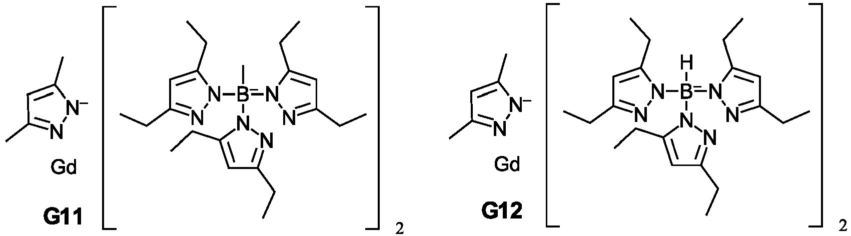

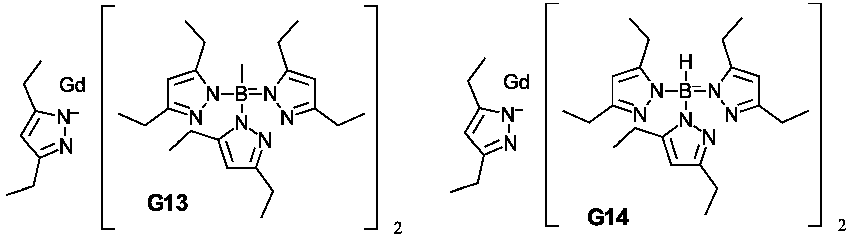

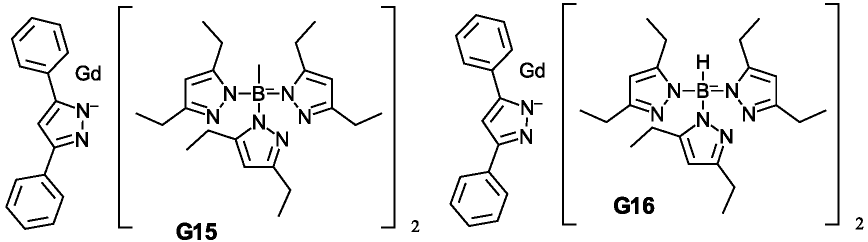

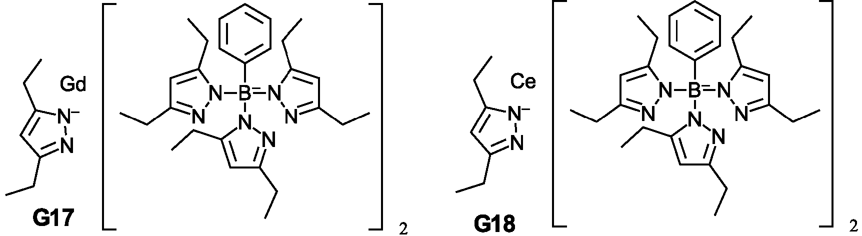

In various embodiments the organic layer being part of the electroluminescent device according to the invention is configured as light emission layer and comprises organic emitter compounds besides the metal organic coordination compound according to formula (1-1). In various embodiments at least one phosphorescent emitting material is additionally present. Preferably, the phosphorescent emitting material emits substantially in the blue spectral region, and/or comprises a metal cation selected from Pt(II) or Ir(III). In various other embodiments at least one fluorescent, hyperfluorescent, or TADF-type emitting organic material is additionally present. Preferably, the fluorescent material comprises one or more six-membered heteroaryl or heteralkyl rings comprising one or more boron atoms in combination with (nitrogen and/or oxygen) atoms as part of the ring.

The metal-organic coordination compounds according to formula (1-1) can have excellent hole transporting capability and in various embodiments the organic layer comprising the metal organic coordination compound according to formula (1-1) is configured as hole transporting layer. The hole transporting layer can be adjacent to any of the electrodes, preferably the anode, or can be a layer not in contact with any of the electrodes, for example as part of a charge generation layer. The hole transport layer can substantially only comprise the metal organic coordination compound but can as well be mixed with one or more additional material, for example a redox dopant, capable of generating free holes.

The metal-organic coordination compounds according to formula (1-1) can have excellent volatility and high solubility, and in various embodiments, the metal-organic coordination compound according to formula (1-1) is deposited from gas phase, preferably using an evaporation and/or sublimation and/or carrier gas process, or is deposited from solution. Thermal sublimation and/or evaporation are the standard processes used in industrial consumer display production processes and given the high sublimation yield of the materials according to the invention, fabricating organic electroluminescent devices, for OLED consumer displays, is readily possible using those processes. Alternatively, the coordination compound applied in the organic electronic device is deposited from solution, which can offer advantages in terms of throughput or production cost.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** exemplifies metal-organic coordination compounds that might be present in electroluminescent devices according to the invention as well as comparative examples
**FIG. 2, FIG. 3** and **FIG. 4** illustrate schematic cross sections of electroluminescent devices according to various aspects.
**FIG.** 5 depicts photoluminescence spectra of a metal-organic complex that might be used in examples according to the invention in comparison to a comparative compound.
**FIG. 6** and **FIG. 7** depict single carrier devices of a metal-organic complex that might be used in examples according to the invention in comparison to a comparative compound.
**FIG. 8** to **FIG. 11** depict various device characteristics of electroluminescent devices according to various embodiments of this invention as well as comparative examples.

### Detailed Description

The following detailed description refers to the accompanying drawings that show, by way of illustration, specific details and aspects in which the invention can be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to metal-organic compounds coordinated by three anions with two of those anions comprising a bor covalently bound to four atoms or organyl groups, respectively. The borate anion by itself is thus not a coordination compound, because all metal organic bonds are of covalent nature.

In this description, a coordination compound is taken to mean a compound where the central metal, for example a lanthanide, is coordinated without a direct metal-carbon bond. The terms complex, metal-organic compound, and coordination compound will be used interchangeably. The positively charged metal is repeatedly referred to as "the cation" and it will be in a positive oxidation stage.

In this description, a coordination compound is considered homoleptic complex if the central metal cation is coordinated by only one type of anion. If the central metal cation is coordinated by a plurality of anions, the coordination compound is considered a heteroleptic complex. Therefore, the compounds according to formula (1-1) are exclusively heteroleptic ones and all inventive electroluminescent device embodiments use heteroleptic coordination compounds.

As used herein, "deuterium" refers to an isotope of hydrogen. Deuterated compounds can be readily prepared using methods known in the art.

It is to be understood that when a molecular fragment is described as being a substituent or otherwise attached to another moiety, its name can be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably the at least one heteroatom is selected from O, S, N, P, B, and Si, more preferably O, or N. Preferably 1 to 5, more preferably 1 to 3, most preferably 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably the at least one heteroatom is selected from O, S, N, P, B, and Si, more preferably O, S, or N. The term hetero-aromatic cyclic radical may be used interchangeably with the term heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be optionally substituted, e.g., by halogen, deuterium, alkyl or aryl.

The term "aryl" refers to and includes both single-ring aromatic hydrocarbon groups and polycyclic aromatic ring systems. The polycyclic rings can have two or more rings in which two carbons are common to two adjoining rings (the rings are "fused") or wherein one carbon is common to two adjoining rings (e.g., biphenyl) wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl, and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both single-ring aromatic groups and polycyclic aromatic ring systems that include at least one heteroatom. The heteroatoms include but are not limited to and are preferably selected from O, S, N, P, B, and Si. In many instances, O, S, or N are the preferred heteroatoms. Hetero-single ring aromatic systems are preferably single rings with 5 or 6 ring atoms, and the ring can have from one to five/six, preferably 1 to 3 heteroatoms. The hetero-polycyclic ring systems can have two or more rings in which two atoms are common to two adjoining rings (the rings are "fused") or wherein one carbon is common to two adjoining rings (e.g., bipyridine) wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

Generally, aryl and heteroaryl groups with triplet level >2.5 eV or more preferably >2.6 eV or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or low polarizable, hard heteroaryl groups, such as 1,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted with one or more (general) substituents, preferably the substituents mentioned herein.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof, with the number of carbon atoms and heteroatoms as defined above for the respective term.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof, with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof, with the number of carbon atoms and heteroatoms as defined above for the respective term.

The terms "substituted" and "substitution" refer to a substituent other than H that is bonded to the relevant position, e.g., a carbon or nitrogen. For example, when R represents monosubstitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

In all embodiments of this invention, a plurality of substituted pyrazolyl (i.e. heteroaryl) rings or groups is present with the coordination compounds used in electroluminescent devise according to the invention as part of the borate anion according to formula (1-1). Referring to formula (1-1), three pyrazolyl groups are covalently bonded to the boron via one of its nitrogens each, while the adjacent, second nitrogen of the pyrazolyl groups can form a coordination bond with the central metal cation being Gd3+ or Ce3+. Each borate contains at least three, preferably identical, pyrazolyl rings, all of which are substituted at least in 3- and 5-position, optionally also in 4-position. Within this description the conventional numbering of the pyrazole ring atoms with its two neighboring nitrogens being labeled as positions 1 and 2 is followed:

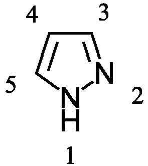

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the macrocyclic ring present as part of the coordination compound. In some instances, a pair of substituents present on the same carbon atom can be optionally joined, i.e., into an aryl or heteroaryl group, thus, forming a spiro linkage on said particular carbon atom.

In this description, the term "organyl" refers to any chemically stable organic arrangement of atoms which includes at least one carbon atom and at least one further atom, where one or more hydrogen atom have been removed such as to use those free vacancies to covalently link the organic ("organyl") group with another molecular entity. Thus, the term organyl encompasses the majority of the above defined organic groups e.g. alkyl, cycloalkyl, heteroalkyl, alkoxy, aryloxy, alkenyl, cycloalkenyl, heteroalkenyl, aryl, heteroaryl, nitrile, isonitrile, and combinations thereof with the number of carbon atoms and heteroatoms as defined above for the respective term. The term organyl shall especially as well encompass sufficiently chemically stable negatively charged species, such as anions, or anionic side groups.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included. Further, it shall be irrelevant in this context whether the emitted light stems from an intrametallic, intraligand or charge-transfer transition between the ligand and a metal.

In the technical field of OLEDs, the emission is usually classified as fluorescence if it originates from an optically allowed (spin-conserving) transition and decays within a few nanoseconds, such as the transition from the first excited singlet state to the singlet ground state, or, as phosphorescence if the emission originates from a spin-forbidden transition and decays with a few micro-milliseconds, such as from the first excited triplet state to the singlet ground state. The Ce3+ complexes derived from the generic formula (1-1) can be specifically useful as deep blue emitting electroluminescent emitters for OLED applications. The emission from the first electronically excited Ce(lll) results in an optically allowed spin-conserving d-f transition, which has a rather long excited state lifetime of around 35 ns, which is significantly longer as observed for typical fluorescent emitters. Thus, it clearly is neither fluorescent, nor phosphorescent in the typical context used in OLED community. It should correctly be referred to as emission from an intrametallic transition.

All embodiments of the invention concern electroluminescent devices that contain a metal-organic coordination compound, wherein the coordination compound comprises at least two, preferably identical, pyrazolyl borate anions being described by the generical formula (1-1): 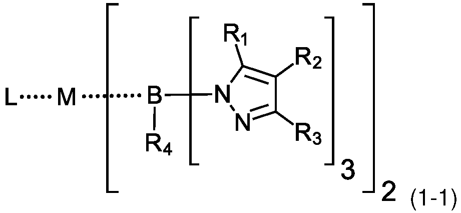 with definitions of **R₁** to **R₄,** the broken lines, and **M** being defined as above. Formula (1-1) generates metal organic compounds comprising a central Gadolinium or Cerium cation that is coordinated by three ligands. At least two of those three coordinating ligands are pyrazolyl borates. There are at least three, preferably identical, pyrazolyl groups covalently bonded to each boron atom. According to the invention those pyrazolyls are in each instance, preferably identically, substituted with an organyl group having 6 or more atoms in 3- and 5-position. The fourth position on the boron can by unsubstituted (that is: hydrogen) or the hydrogen is substituted by another atom or organyl group. This fourfold covalently bond boron complex is singly negatively charged and as such an organic anion known as borate. A plurality of nitrogen atoms present in the at least six pyrazolyls is able to form multiple coordinative bonds towards the metal cation, which lead to those borate anions to be named as "scorpionates".

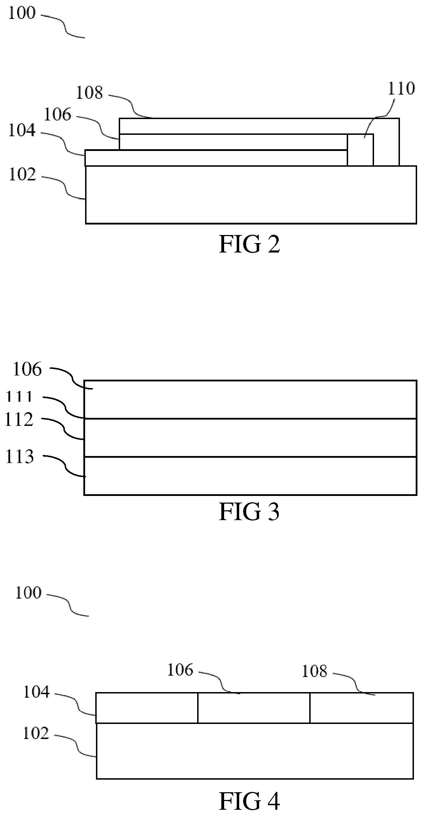

In general, substituents R₁ and R₃ can each identically be any chemical fragment with six or more atoms individually that can be covalently attached in accordance with formula (1-1) to the pyrazolyl ring. In various preferred examples R₁ and R₃ represent organyl groups with six or more atoms. A wide range of substitutions can be envisioned by those skilled in the art and are in the scope of the invention. Without limiting this general scope, some examples of individual charge neutral substituents are s11 to s71 illustrated in Figure 2 of WO 2023/194363 which is included in the present description as a whole. Those fragments are meant as illustration and many more side groups can be chosen, depending on the final application within the electroluminescent device according to the invention. For example, linear or branched alkane side chains can be chosen if a good solubility in non-polar solvents is needed. Examples are given as S11 to S28 in Fig. 2 of WO 2023/194363. Such substituents can as well suppress intermolecular interactions and generally improve the film formation, for example after processing through a gas transfer process. Generally preferable for the design of electroluminescent devices are organic materials with high thermal stability, for example suitable for evaporation or sublimation. In this case, preference is given to small and light weight substituents, i.e organyl fragments with individually less than 20 atoms and or individually a molecular weight of less than 100 g/mol. Similarly, halogenated, particularly fluorinated, side groups, such as depicted in S11 to S15 in Fig. 2 of WO 2023/194363 can improve volatility and/or stability of the coordination compound. In case the intended application of the coordination compound of the invention is light generation within the electroluminescent device, the ligand preferably can be chosen such that the excitation of the coordination compound is confined to the central metal cation of the coordination compound according to the invention, for example in the case of Ce(III). In this way, a light-generating intrametallic transition with highest efficiency is obtained. In this particular situation, preferred substituents are side groups that do not easily polarize and that have a sufficiently high lowest triplet energy. Low polarizability is ensured for aliphatic or heteroaliphatic substituents or using small aryl- or heteroaryl systems with less than eight conjugated atoms or heteroatoms. "sufficiently high triplet energy" obviously depends on the emission color of the complex, specifically if the coordination compound is intended to emit in the visible and in particular in the deep blue spectral region, for example realized by using Ce3+ as central metal, then side groups with a triplet energy >2.5 eV, or preferably >2.7 eV should be used. Sufficiently high triplet energy >2.7eV is generally observed for organyl groups comprising of aliphatic or heteroaliphatic fragments or for fragments comprising only small aryl- or heteroaryl systems with less than 8 conjugated atoms or heteroatoms, which thus should preferably be employed substituents if a deep blue electroluminescent emitter is the intended use of the coordination compound according to the invention. Examples of suitable side groups with respect to their triplet energy level are s11 to s71 illustrated in Fig. 2 of WO 2023/194363. Of specific interest are relatively small branched or linear alkyl or heteroalkyl chains or aryl or heteroaryl groups. Within the aromatic aryl and heteroaryl groups of most interest is their smallest member, phenyl, depicted as S46 in Fig. 2 of WO 2023/194363. A wide variety of alkyl and heteroalkyl and cycloalkyl substitutes is well suitable and surely within the scope of the invention. Without limiting this wide scope preference is given to non-polarizable side groups such as alkyl chains, and further general preference is given to small variants having less than 40 atoms, or preferably less than 20 atoms. Without limiting the scope of the invention, preference is given to alkyl substituents selected from ethyl, propyl, isopropyl, n-butyl, tert-butyl and derivatives thereof where one or more hydrogens are substituted by deuterium or halogen, preferably fluorine. More preferred are substituents selected from ethyl, propyl, and isopropyl and their partly or fully fluorinated or deuterated analogs, and most preference is given to all substituents R₁ and R₃ being non-substituted ethyl. It is understood that the small selection of organyl groups depicted in the reference serves as example only and do not constituent a preferred selection. Many more substituents can be envisioned by those skilled in the art. For example, the given examples S11 to S71 depicted in Figure 2 of WO 2023/194363 can be further substituted by replacing a suitable hydrogen or deuterium with an organyl group or a different atom. For example, three hydrogens of the phenyl substituent depicted as S46 can be substituted by methyl groups such that the substituent is a mesityl, which may be preferred for some specific applications. In general, substituents R₂ and R₄ can each individually be hydrogen or any atom or chemical fragment that can be covalently attached in accordance with formula (1-1). In various preferred examples R₂ and R₄ represent hydrogen, halogens, deuterium or low molecular weight organyl groups. A wide range of substitutions can be envisioned by those skilled in the art and are in the scope of the invention. Without limiting this general scope, some examples of individual charge neutral substituents are s2 to s71 illustrated in Figure 2 of WO 2023/194363. Those fragments are meant as illustration and many more side groups can be chosen, depending on the final application within the electroluminescent device according to the invention. For example, linear or branched alkane side chains can be chosen if a good solubility in non-polar solvents is needed. Examples are given as S11 to S28 in Fig. 2 of WO 2023/194363. Such substituents can as well suppress intermolecular interactions and generally improve the film formation, for example after processing through a gas transfer process. Generally preferable for the design of electroluminescent devices are organic materials with high thermal stability, for example suitable for evaporation or sublimation. In this case, preference is given to small and light weight substituents, i.e organyl fragments with individually less than 20 atoms and or individually a molecular weight of less than 100g/mol. Similarly, halogenated, particularly fluorinated, side groups, such as depicted in S11 to S15 in Fig. 2 of WO 2023/194363 can improve volatility and/or stability of the coordination compound. In case the intended application of the coordination compound of the invention is light generation within the electroluminescent device, the ligand preferably can be chosen such that the excitation of the coordination compound is confined to the central metal cation of the coordination compound according to the invention, for example in the case of Ce(III). In this way, a light-generating intrametallic transition with highest efficiency is obtained. In this particular situation, preferred substituents are side groups that do not easily polarize and that have a sufficiently high lowest triplet energy. Low polarizability is ensured for aliphatic or heteroaliphatic substituents or using small aryl- or heteroaryl systems with less than eight conjugated atoms or heteroatoms. "sufficiently high triplet energy" obviously depends on the emission color of the complex, specifically if the coordination compound is intended to emit in the visible and in particular in the deep blue spectral region, for example realized by using Ce3+ as central metal, then side groups with a triplet energy >2.5 eV, or preferably >2.7 eV should be used. Sufficiently high triplet energy >2.7eV is generally observed for organyl groups comprising of aliphatic or heteroaliphatic fragments or for fragments comprising only small aryl- or heteroaryl systems with less than 8 conjugated atoms or heteroatoms, which thus should preferably be employed substituents if a deep blue electroluminescent emitter is the intended use of the coordination compound according to the invention. Examples of suitable side groups with respect to their triplet energy level are s2 to s71 illustrated in Fig. 2 of WO 2023/194363. It is understood that the small selection of organyl groups depicted in the reference serves as example only and do not constituent a preferred selection. Many more substituents can be envisioned by those skilled in the art. For example, the given examples S11 to S71 depicted in Figure 2 of WO 2023/194363 can be further substituted by replacing a suitable hydrogen or deuterium with an organyl group or a different atom. For example, three hydrogens of the phenyl substituent depicted as S46 can be substituted by methyl groups such that the substituent is a mesityl, which can be preferred for some specific applications.

Of specific interest are relatively small branched or linear or cyclic alkyl or heteroalkyl chains or aryl or heteroaryl groups. Within the aromatic aryl and heteroaryl groups of most interest is their smallest member, substituted or non-substituted phenyl. If the general aryl or heteroaryl group or the specific phenyl group is further substituted than of specific interest are low molecular substitutions such as single halogen atoms, preferably fluorine, deuterium or short alkyls such as methyl, a preferred substituent for R₂ and R₄ is therefore mesityl. A wide variety of alkyl and heteroalkyl and cycloalkyl substitutes is well suitable and surely within the scope of the invention. Within limiting this wide scope preference is given to non-polarizable side groups such as alkyl chains, and further general preference is given to small variants having less than 40 atoms, or preferably less than 20 atoms. Without limiting the scope of the invention, preference is given to alkyl substituents selected from ethyl, propyl, isopropyl, butyl, tertbutyl and derivatives thereof where one or more hydrogens are substituted by Deuterium or halogens, preferably fluorine. The substituents R₁ and R₃ can as well single atoms, such as depicted as S2 to S7 in Figure 2 of WO 2023/194363. Of specific interested are fluorine and deuterium, and small (in)organic groups such as nitrile. In the most preferred embodiments R₁ and R₃ is either each individually not substituted or substituted by deuterium, fluorine, methyl, ethyl, propyl, phenyl, or mesityl.

The metal-organic coordination compound according to formula (1-1) used in all embodiments of the inventions comprises three anions of which at least two are borates. The third anion can be any singly negatively charged (that is anionic) single atom or chemical composition. A small selection of singly negatively charged anions depicted as a1 to a5, a7 to a9, a11, a12, a14, a16, a18, a20, a21, a23, a24, a27, a29 to a33, a36 to a 47, and a49 to a51 in Figure 4 of WO 2023/194363, which is included as a whole, can serve to further exemplify the scope of the invention. Within the scope of the invention are singly negatively charged atoms, specifically halogens, and inorganic anions comprising a plurality of atoms. Without limiting the full scope of the invention, some examples such inorganic anions are a1 to a5, a7 to a9, a11, a12, a14, a16, a18, a20, a21, and a23 shown in Figure 4 of WO 2023/194363. Preferably, the ligand L of formula (1-1) is an organic anion and a few examples are depicted as a24, a27, a29 to a33, a36 to a 47, and a49 to a51 in Figure 4 of WO 2023/194363. Various embodiments include L being a heteroleptic or homoleptic borate type anion as depicted in the examples before. Of specific interest for this disclosure are electron rich organic anions based on a substituted or non-substituted heterocyclic ring that are able to coordinate to a metal cation and can afford blue emitting compounds if coordinated to Ce(3+) according to formula (1-1). In various examples, the ligand L can be a nonaromatic substituted or non-substituted ring. In various preferred examples the ligand L has an aromatic structure, and it is selected from a substituted or non-substituted heteroaryl group. In various preferred embodiments the auxiliary ligand L is selected from imidazolyl, pyrazolyl, 1,2,3-triazolyl, 1,2,4-triazoyl, and benzimidazolyl. In more preferred embodiments those heteroarylic anions are substituted and the ligand L is selected from a substituted imidazolyl, pyrazolyl, 1,2,3-triazolyl, 1,2,4-triazoyl, and benzimidazolyl. A wide variety of organic and inorganic substitutions is within the scope of the invention and a few examples of possible substitutions are given as S2 to S71 in Figure 2 of WO 2023/194363. While many substitutions can be present, of specific interest are comparable light weight and non-polarizable organyl groups. Therefore, the preferred substituents can be selected from methyl, ethyl, (iso-)propyl, (tert-)butyl, phenyl, and mesityl. Most preferred L is a pyrazolyl that is disubstituted in 3,5-positions with both substituents being identical.

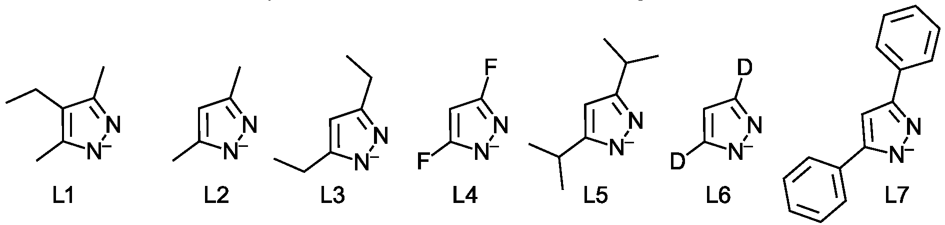

Some examples to illustrate the scope of such preferred ligands L are depicted as L1 to L7 above. All depicted substitutions are symmetrically applied to the pyrazolyl, i.e. identically in 3- and 5-position. The substitution can be deuterium as shown in L6, or it can be a single atom, specifically a halogen as exemplified in L4. Preferably the substituents are low molecular weight alkyl chains or aryl rings. L1, L2, L3, L5 exemplify low molecular weight linear and branched alkyl chains, while L7 illustrates the use of the smallest aryl, namely phenyl. The position 4 of the pyrazolyl can be hydrogen or substituted. In the latter case, low molecular and non-polarizing substituents are preferably used. L1 illustrates the situation of a ligand L being pyrazolyl that is substituted in position 4 using a methyl organyl group.

In various preferred embodiments the auxiliary ligand, L in formula (1-1), is a pyrazolyl with identical substitution pattern as those pyrazolyls present as part of the borates in formula (1-1). In other words, the pyrazolyl is identically substituted in 3- and 5-position with an organyl group having 6 or more atoms. In this case the generic formula (1-1) can be simplified into formula (1-2): 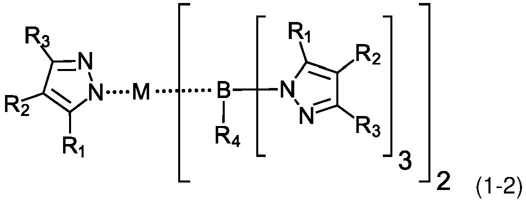 with R₁ to R₄, the broken lines, and M being defined as above. This particular class of metal organic compounds in which all 7 pyrazols are identically substituted and therefore identical can be less prone to form isomers and can as such be easier to synthesize and to purify.

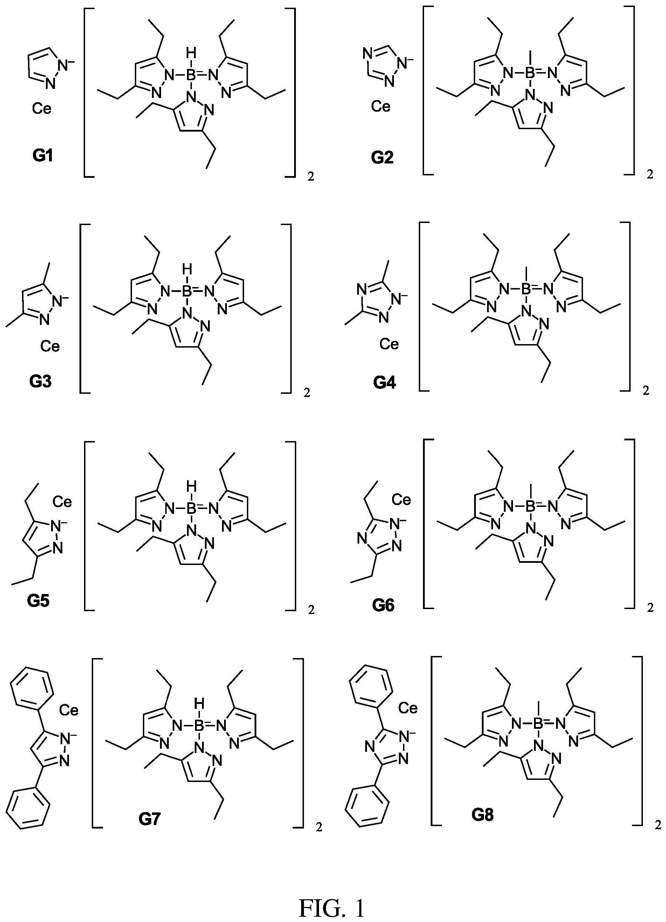

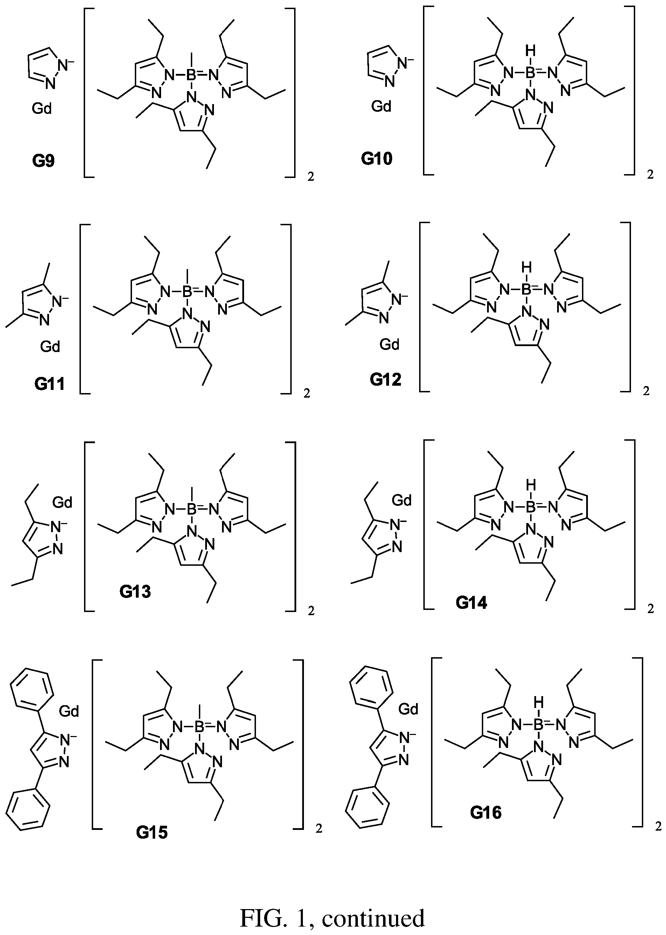

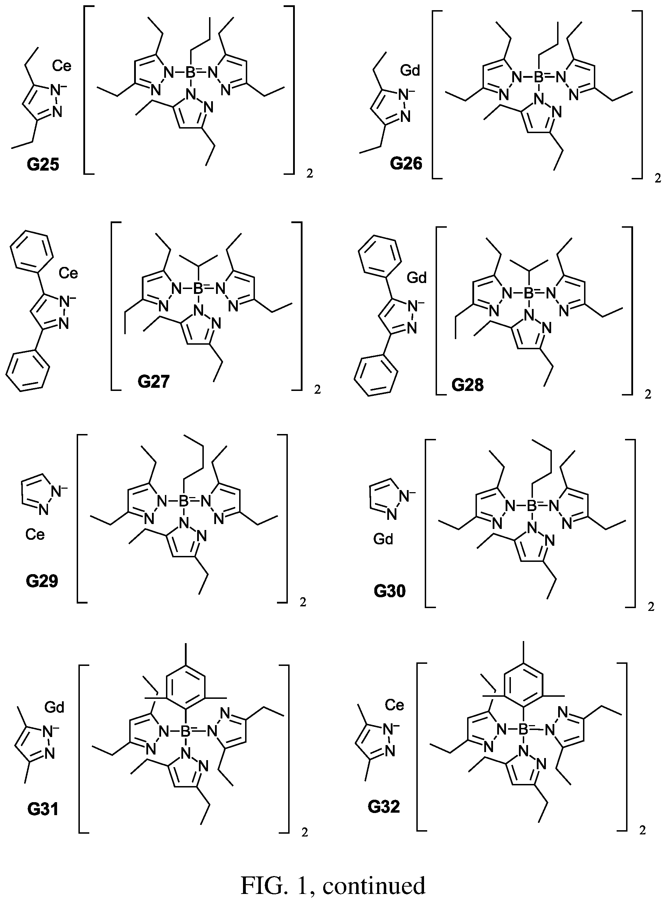

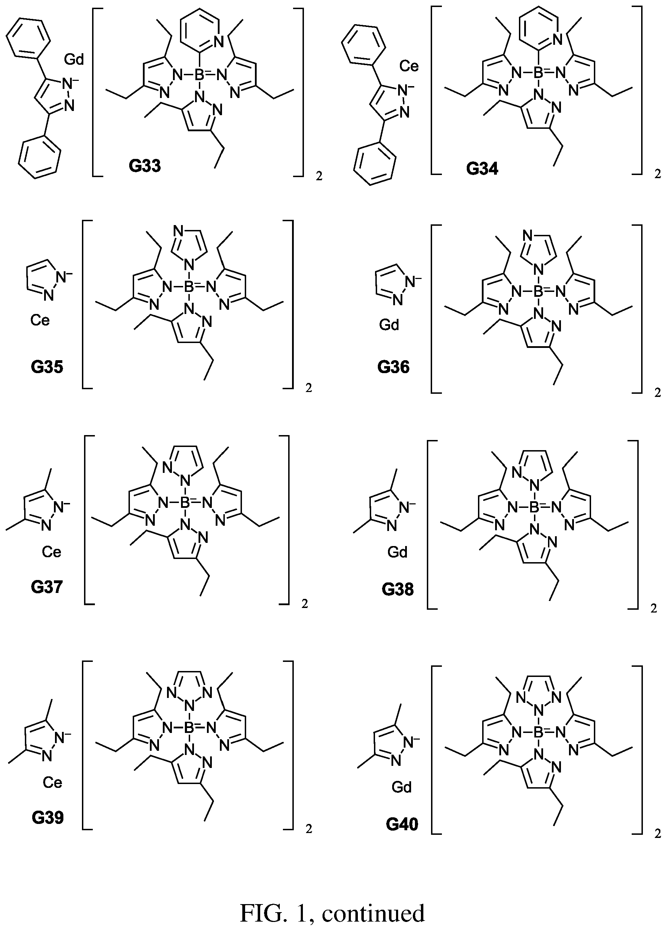

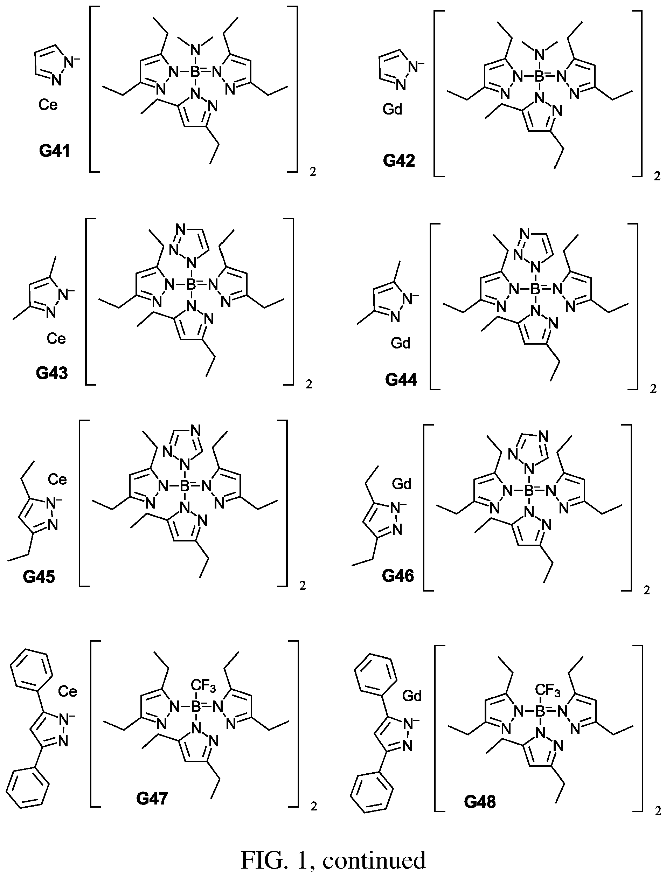

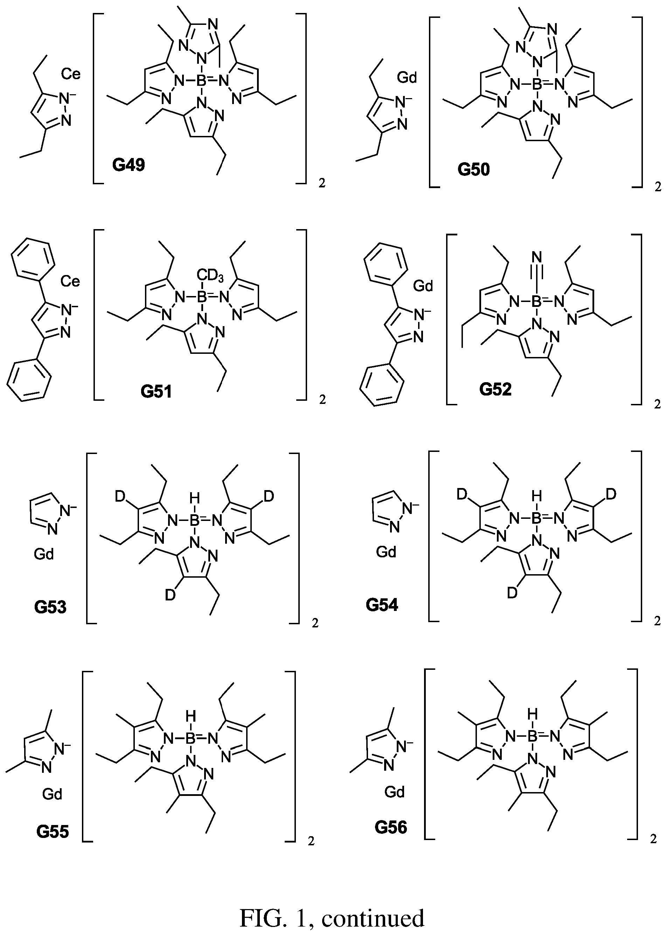

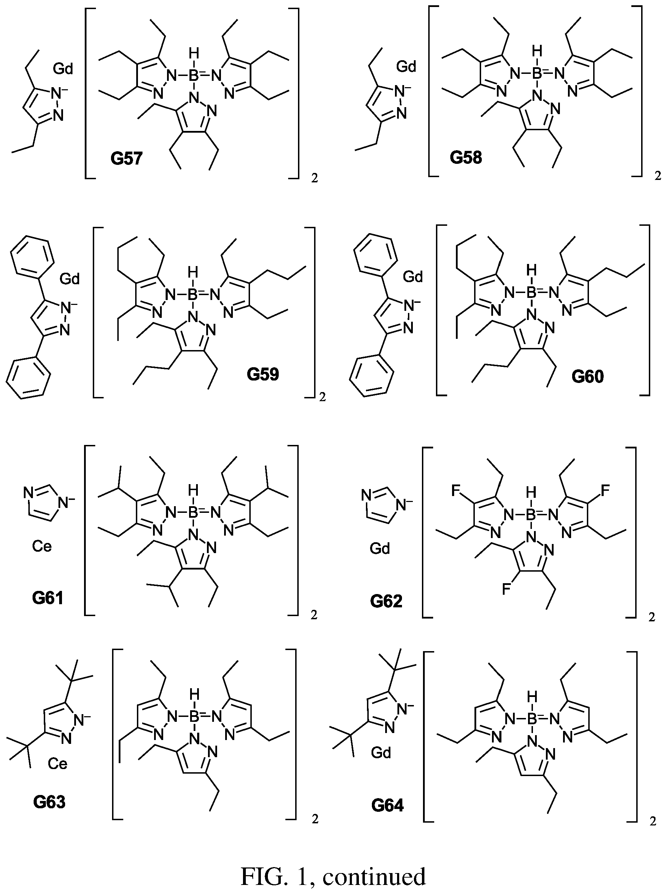

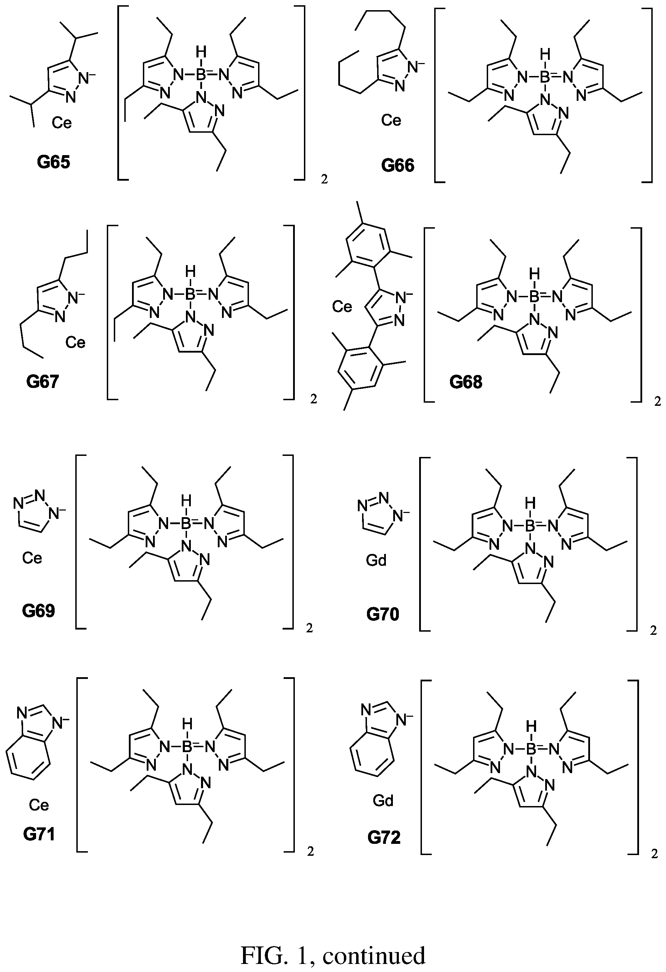

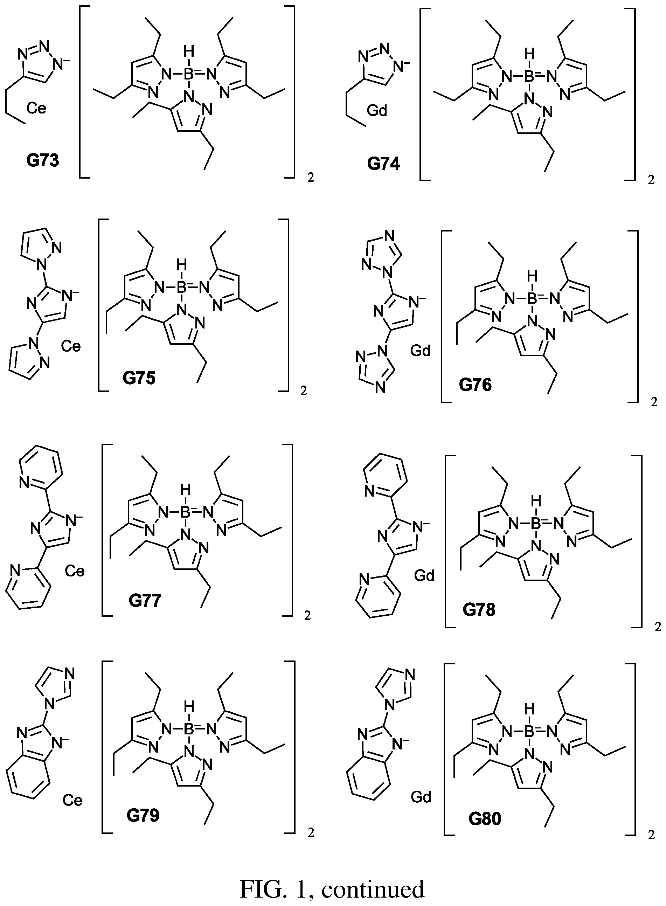

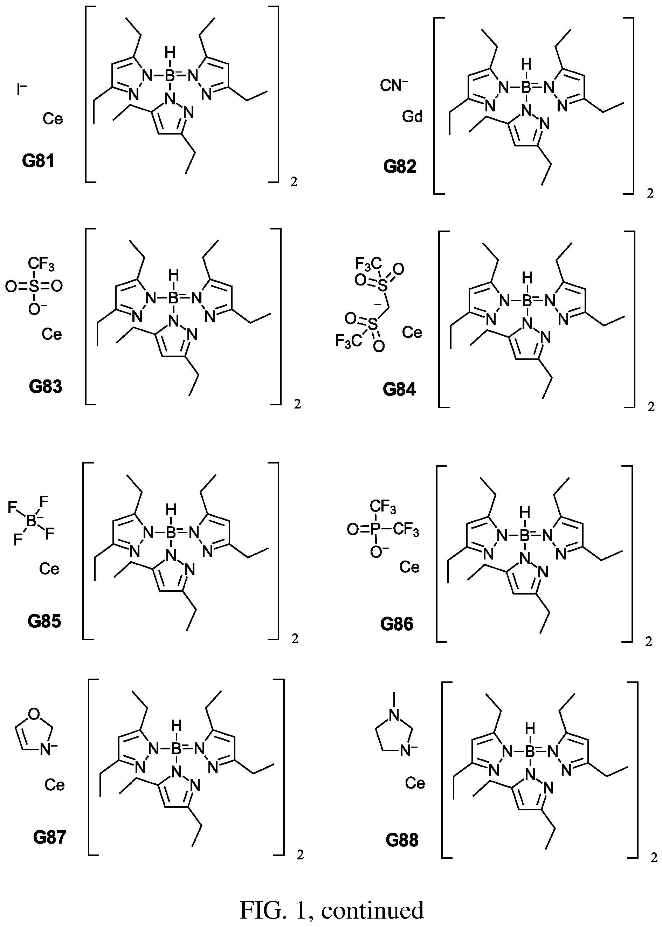

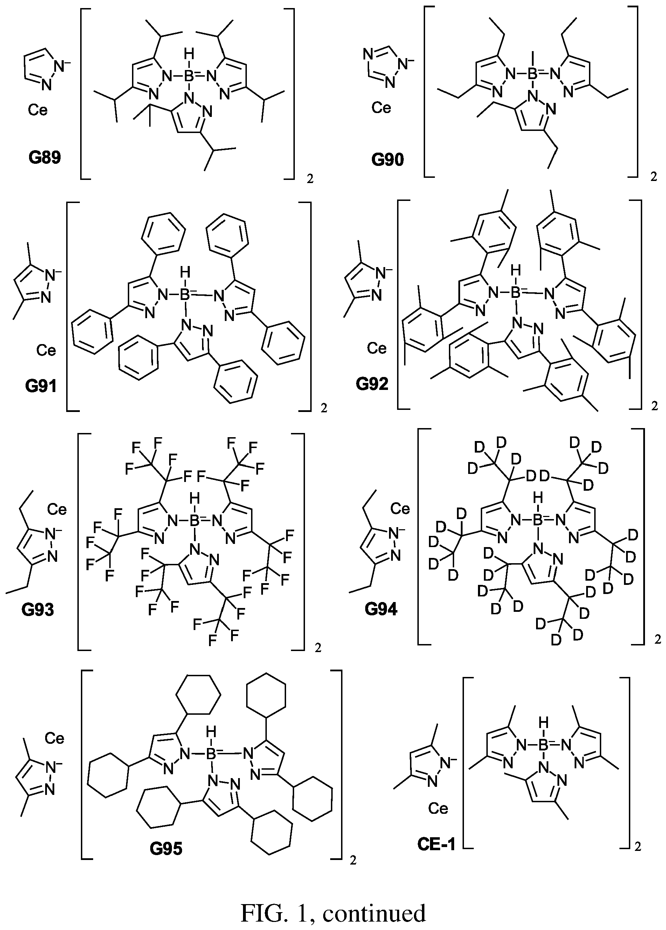

Without limiting the scope of the invention, G1 to G91 shown in **FIG. 1** further illustrate examples of ligands according to formula (1-1). The concrete compounds depicted serve for illustration purposes and shall help to show the scope of the invention. In this context, most of the possible substituents that can be present on certain carbon or heteroatoms have been omitted for clarity. They may nevertheless be present. It is understood that those are specific examples only which should not limit the wider combinatorial scope of the invention. According to the invention, the examples shown in Fig. 1 are charge neutral metal-organic coordination compounds derived from the formula (1-1), in which the central metal is selected from Cerium(III) or Gadolinium(III).

All the structures exemplified contain two identical borate ligands which each contain three identical heterocyclic rings and R₄ according to formula (1-1). Those three rings are in all cases additionally identical in their substitution pattern, if any is present. In all examples depicted in Fig. 1 three identical heterocyclic rings with identical substitution pattern, according to formula (1-1), are shown for illustration. In all examples in Fig. 1, R₁ and R₃ are identically substituted and R₂ can be a different substituent. In the vast majority of the examples in Fig. 1 R₂ is hydrogen, i.e. non-substituted. Hydrogen can be substituted by Deuterium, which may offer superior stability, and which is exemplified in G53 and G54, or fluorine (G62), or an organyl group, preferably methyl, ethyl or (iso-)propyl as exemplified in examples G55, G56, G57, G58, G59, G60 and G61. According to the invention, in most of the examples shown in Fig. 1 R₁ and R₃ are alkyl substituted, preferably ethyl. In G89, G90, G91, G92, G93, G94 and G95 R₁ and R₃ are both identical substituted or unsubstituted alkyl or aryl groups, specifically substituted alkyl and aryl, more specifically isopropyl, cyclohexyl, perfluorated ethyl, deuterated ethyl, phenyl or mesityl.

The fourth borate ligand R₄ is in the majority of examples in Fig. 1 exemplified as hydrogen or methyl. In various examples in Fig. 1 R₄ can be a deuterium (G19 and G20), fluorine (G21. G22), nitril (G52), a linear or branched heteroalkyl (G41, G42, G47, G48 and G51) or alkyl. The alkyl group is preferably selected from ethyl, propyl, iso-propyl and butyl, examples according to this situation are depicted as G23, G24, G25, G26, G27, G28, G29 and G30, respectively. According to the formula (1-1) R₄ is selected from substituted or non-substituted aryl, preferably from phenyl (G17, G18) and mesityl (G31, G32). Within the scope of the invention, R₄ can as well be a substituted or non-substituted heterocycle. Examples of such can be pyridyl (G33 and G34), pyrazoyl (G37, G38), 1,2,3-triazoyl (G39, G40, G43, G44), 1,2,4-triazoyl (G45 and G46), imidazoyl (G35 and G36), and 3,5-disubstituted triazoyl (G49 and G50).

According to the invention, additional to the two identical borate ligands the metal is also coordinatively bound to a singly electrically negatively charged ligand L. The examples G1 to G91 shown in Fig. 1 exemplify the situation of one ligand L being present as part of such heteroleptic complex, that is a complex that comprises of two borate type anions and one further anion not identical to the two borates. Generally, the ligand L can be an inorganic anionic ligand, preferably iodide (G81), nitril (G82), triflate (83), bis(trifluormethyl)sulfonylmethyl (G84), tetrafluoroborate (G85) and bis(trifluormethyl)phosphinyl (G86). In various preferred examples, the anionic ligand L can be an organic ligand and can specifically be selected from substituted or non-substituted heterocycles. It may be that the heterocyclic ligand L is a non-aromatic, substituted or non-substituted ligand, as for example in G87 with oxazolinyl, imidazolidine (G88). In various other embodiments, the heterocyclic ligand L is aromatic and is selected from imidazoyl (G53, G54), 1,2,3-triazoyl (G69, G70), 1,2,4-triazoyl (G2, G90), benzimidazoyl (G71, G72), substituted with linear or branched alkyl or aryl like pyridyl (G77, G78), pyrazoyl (G75), triazoyl (G76), imidazoyl (G79 and G80) and mesityl (G68). The preferred substituted or non-substituted heterocyclic ring is pyrazolyl, and the majority of compounds in Fig. 1 are depicted accordingly. For applications requiring different physical or chemical properties, it may be beneficial to substitute some hydrogens by linear or branched alkyl or aryl groups, preferably substituted in the 3,5-position with both substituents being preferably identical, and preferably being selected from methyl and ethyl. Many examples according to this situation are exemplified in Fig. 1. The preferably pyrazoyl heterocycle can also be substituted in the 3,5-position with (iso-)propyl (G65), (tert-)butyl (G63, G63 and G66) or phenyl, which is illustrated in various examples in Fig. 1, or substituted phenyl, preferably mesityl (G68).

Besides anionic groups, the metal-organic coordination compound according to the invention can comprise of additional charge neutral organic or non-organic groups and which are not explicitly shown in formula (1-1). Of particular interest are organic coordinating ligands that help to fill the coordination sphere of the central metal cation, thereby creating a robust material suitable for the design of electroluminescent devices. In various embodiments, tetrahydrofuran or acetonitrile are part of the metal-organic coordination compound according to the invention. For intended use of the metal-organic coordination compound according to the invention as deep blue emitter, Ce(lll) might be the preferred metal cation and preferably no further charge neutral auxiliary ligand is present.

The combination of the chemical robustness with the ability to form very stable coordination compounds make metal-organic coordination compounds according to formula (1-1) highly attractive for application in organic electronic devices, and specifically in electroluminescent device, for example by using the materials according to the invention as emitter materials. In this description, an electroluminescent electronic device can be any device or structure including substantially organic layers or subunits, where a voltage or current stimulus can be converted into electromagnetic radiation. In various embodiments the emission is substantially in the visible spectral region, for example in the range from 430 to 780 nm. In various other embodiments the emission is partly of completely invisible to the human eye and can be in the near infrared spectral region for example from 780 to 1600 nm. Combinations of the two and complete or partial emission at shorter wavelength than visible light are in the scope of the invention too. Preferably, the electroluminescent device according to the invention emits light in the visible spectral region, and more preferably in the blue spectral region, with the generated light being substantially emitted from 430 to 500 nm. The coordination compounds according to various embodiments can have desirable material properties such as a deep blue emission spectrum combined with high operational stability. In particular, and preferably, using lanthanide coordination compounds with deep blue intrametallic d-f transitions, the coordination compound according to the invention can serve as direct or indirect emitter giving rise to excellent device characteristics. Of special interest in this respect and preferred are emitters based on Ce(III). Given their high atomic weight and open shell doublet multiplicities, the optical transition of this preferred lanthanide cation can be as well widely indifferent to excitation with either spin 1 or spin 0 electron-hole pairs. In other words, singlet and triplet excitations are harvested, resulting in high light emission efficiency. As such, the coordination compounds according to various embodiments comprising Ce(lll) can be ideally suited for application in visible, particularly deep blue emitting, organic light emitting diodes and devices.

**FIG. 2** to **FIG. 4** illustrate embodiments of an electroluminescent device 100. The device can include a first electrode 104, e.g. on a substrate 102 or as the substrate; a second electrode 108; and an organic layer 106 arranged such that it is electrically interposed between the first and second electrodes 104, 108. The first and second electrodes 104, 108 can be electrically insulated from each other by an insulating structure 110, e.g. a resin or polyimide. The first and second electrodes 104, 108 can be stacked over each other (FIG. 2) or can be arranged in a common plane (FIG. 4).

The organic layer 106 can include the coordination compound according to any of the described or illustrated embodiments, e.g., the layer can contain just the coordination compound, or a mixture with a further organic or non-organic material.

The organic layer 106 is arranged electrically between the first and second electrodes 104 and 108, such that an electronic current can flow from the first electrode 104 through the organic layer 106 to the second electrode 108 and vice versa during operation, e.g., during light emission. In other words, upon application of sufficient voltage, holes and electrons are injected from the anode and the cathode, respectively. From there, they drift towards the organic layer 106, where charges of opposite sign recombine to form a short-lived localized excited state. The short-lived excited state can relax to the ground state thereby giving rise to light emission. The organic layer 106 may or may not comprise mobile anions of organic or inorganic nature. Such mobile anions may rearrange upon application of sufficient electric field upon application of sufficient voltage between the electrodes 104 and 108. Such device is typically referred to as an organic light emitting cells (LECs) and within this description is considered as a subclass of electroluminescent devices comprising mobile charged species inside the active organic layer 106, which are able to drift inside an external applied electrical field. As such OLEDs encompass LEC type devices.

The first and second electrodes 104, 108 can be substantially unstructured layers, e.g., for general lighting applications, or can be structured, e.g., for light emitting diodes for pixels in a display application.

The organic electronic device 100 can be configured to emit substantially monochromatic light, such as red, green, blue, or polychromatic light such as white. The light can be emitted through the first electrode 104 (bottom emitter), through the second electrode 108 (top emitter), or through first and second electrodes 104 and 108 (bidirectional emitter). The light can as well be emitted substantially in a direction parallel to the organic layer 106 using suitable opaque electrodes 104 and 108. In such a layout, lasing can be achieved, and the device can be an organic laser, which, in this description, can be considered as a specific type of electroluminescent devices.

Further layers can be formed and in electrical connection between the first and second electrodes 104, 108, e.g., configured for charge carrier (electron or hole) injection, configured for charge carrier transport, e.g. configured for charge carrier blockage or configured for charge generation. Further optically functional layers, e.g. a further electroluminescent material and/or a wavelength conversion material, can be formed between the first and second electrodes 104, 108 and in the optical path of the organic layer 106, e.g. on top of the second electrode 108 and/or on the opposite side of the substrate 102. In addition, encapsulation structures can be formed protecting the electrically active area, e.g., the area in which electrical current flows and can be configured to reduce or avoid intrusion of oxygen and/or water into the electrically active area. Further optically functional layers, e.g. an antireflection coating, a waveguide structure and/or an optical decoupling layer can be formed within the optical light path of the organic layer 106.

As example, hole or electron blocking layers can be used to optimize the individual hole and electron currents through the organic electronic device 100. This will be known to the skilled in the art as charge balance to optimize efficiency and operational stability. In various embodiments, dedicated hole or electron charge transport layers can be present in the organic electronic device 100 to space the emission region from the first and second electrodes 104, 108.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various derivatives of silanes.

In various embodiments, those charge transport layers can include electrical dopant molecules or metals or can be in contact to charge injection layers.

Any of those auxiliary layers can be fully organic or can include inorganic functional moieties. For example, charge transport layers can be made of the class of Perovskite materials.

The coordination compound according to the invention as illustrated or described in any one of the embodiments can be used as a thin substantially organic emission layer 106 of any thickness in the range of 0.1 to 100 nm, preferably in the range of 3 to 40 nm. The concentration of the coordination compound throughout the cross section of the organic layer 106 can be constant or varied. Typical variable concentrations are in the range of 0 to 100 vol%, i.e., the layer can be partially containing either no coordination compound or only coordination compound. Such situations are indeed frequently observed if mobile evaporation sources are employed to co-sublime the organic material with the coordination compound. The emission layer 106 can as well be configured such that the metal-organic coordination compound according to the invention is present in two adjacent layers, with a different second organic material, for example a host, being present in both layers. **Fig. 3** illustrates a schematic cross section through an organic layer 106 comprising 3 organic sublayers 111, 112, and 113. The electroluminescent device according to the invention can for example comprise the combination of a substantially hole transporting material in combination with the coordination compound according to the invention in layer 112, whilst the same coordination compound is mixed with a substantially electron transporting organic host material in layer 113. Alternatively, the concentration of the coordination compound according to the invention imbedded into a single second material can be substantially different thereby again forming two adjacent layers 112 and 113, with preferably different charge transport qualities.

An optional second organic material being present in the layer containing the coordination compound according to the invention such as the organic layer 106 can in various embodiments be a charge transport material to improve charge transport into and through the organic layer 106 or to facilitate charge recombination. Charge transport materials can be any materials that are able to transport either holes or electrons or both types of charges upon applying a suitable electrical field. In particular a charge transport material can be any aryl, or heteroaryl organic compound or any metal complex or any mixture thereof. Without limiting the scope of the invention, examples of materials present in the light emitting layer 106 include carbazole derivatives, including carbazole-phosphine oxide materials, oxadiazole derivatives, triazine derivatives, silane derivatives and any other material or combination of materials with sufficiently high triplet level that can transport charges or otherwise be beneficial the device performance.

In various embodiments, the coordination compound according to formula (1-1) is used as emitting material within the organic layer 106 of the electroluminescent device according to the invention. In various preferred embodiments, the coordination compound according to the invention is not directly emitting light but is in optical contact to a second emitter. The second emitter is preferably part of the organic layer 106 too. Preferably, the optical contact is achieved via direct energy transfer, i.e. so-called Förster resonance energy transfer. In various other preferred embodiments, the charge recombination occurs substantially on the metal organic coordination compound according to the invention and its energy is substantially transferred to a second emitter. In preferred embodiments, and to ease energy transfer the second emitter has a lower excitation energy as compared to the emission energy of the undisturbed coordination compound according to the invention. The second emitter is preferably configured as fluorescent emitter, preferably characterized by a low inter-system-crossing rate. Preferably, and after optical excitation, the intersystem crossing yield is less than 50% and more preferably less than 10%. The fluorescent emitter, often referred to as the terminal emitter, preferably has a partial concentration within the organic layer 106 of less than 10 wt%, preferably less than 5 wt%. In preferred embodiments, the fluorescent emitter has a narrow emission spectrum, preferably in the blue spectral region. In various preferred embodiments, the coordination compound used in the device comprises Ce(III). Further preferred are terminal emitters comprising a rigid polycyclic aromatic framework, specifically comprising a boron-nitrogen heterocycle. Most preferably, the terminal emitter is a substituted derivative of 5,9-diphenyl-5,9-diaza-13b-boranaphtho[3,2,1-de]anthracene, with preferred substitutions being tert-butyl or carbazolyl groups.

The organic layer 106 that contains the coordination compound according to the invention can contain a further organic or inorganic material in a range of 0.1 to 99.0 vol% that is not intended to transport charges. For example, the organic layer 106 can include polymers (in a mixture or as a compound) which can be added to improve film quality and prevent crystallization. Other materials can be added to evenly space the coordination compound inside the organic layer 106.

In various embodiments, the electroluminescent device 100 includes two or more subunits each including at least one light emitting layer. The subunits can be stacked over each other physically separated and electrically connected by a charge generation layer or, alternatively, can be arranged side by side. The subunits can be subpixels of a pixel in a display or general lighting application. The light emitted by the subunits can be mixed to generate a light of a predetermined color. Each subunit can emit light of the same or a different color. The overall light emitted by such an electroluminescent device 100 can contain a narrow spectral region, such as blue, or can contain a wide spectral region such as white, or a combination thereof. In other embodiments one of the subunits is emitting visible light and the second unit is emitting near infrared light. The coordination compound according to the invention illustrated or described in any one of the embodiments may or may not be present in each individual subunit of the device 100.

In various embodiments, the light emitted by the electroluminescent device 100 can be in optical contact to at least one optically active layer, including any optically active materials such as organic molecules or quantum dots. The optically active layer can be a spectral filter element, which can absorb part of the light emitted by the device 100. In another embodiment, the optically active layer can absorb at least part of the light emitted by the organic electronic device 100 and can reemit it at longer wavelengths (wavelength conversion), e.g., by quantum dots. As an example, the organic layer 106 can be configured to emit light substantially at wavelengths shorter than 500 nm and the optically active layer can be configured to substantially reemit light at wavelengths longer than 500 nm. The optically active layer can be placed in between the anode and cathode of the organic electronic device 100 or outside of it. The optically active layer can as well be part of the organic layer 106.

The term "substantially" can refer to (relative) amounts of a compound and typically means at least 80 wt% preferably at least 90 wt%, more preferably at least 95 wt%, specifically 100 wt%, not considering impurities or additives. It can define ranges of 80 to 100 wt% etc. for the content or purity of a compound. This definition refers e.g. to amounts like weight or volume or other parameters like wavelength. For single values, "substantially" allows for a variation or deviation from a given number by 20% or less, preferably 10% or less, more preferably 5% or less, specifically 1% or less. An emission substantially in the deep blue spectral region below 500 nm means that at least 80% of the emission are below 500 nm etc., e.g. of a measured integral of the emission intensity over wavelength. A substantially organic substrate contains at least 80 wt% of organic substances. When not indicated otherwise, % means wt%.

The electroluminescent device 100 can be configured as a large area OLED device used for illumination, signage, or as a backlight. Alternatively, the electroluminescent device 100 can include a plurality of OLEDs arranged in a pixelated layout (plurality of OLED pixels) that are individually connected electrically, e.g., for flat panel display applications. Here, individual pixels can have the capability of emitting light of substantially narrow spectral portions; especially of red, green, and blue. The mixture may or may not be present in any of the individual pixels.

In another embodiment, the individual pixels can be configured to emit white light. Red, green, and blue spectral portions are generated by using suitable filter elements in optical contact with the respective pixelated OLEDs.

In another embodiment, the OLED pixels emit blue light, and the red and green spectral portions can be generated by using a suitable color conversion element in optical contact with the OLED pixels.

In another embodiment, the OLED pixels emit substantially in the near-UV spectral region with wavelength < 450 nm and the red and green and blue spectral portions can be generated by using a suitable color conversion element in optical contact with the OLED pixels.

An electroluminescent device 100 according to various embodiments can be fabricated using a wide range of commonly used techniques, including, but not limited to, deposition of all or some layers, from gas phase vacuum deposition, solution phase, or gas phase using a carrier gas method.

Owing to the high volatility of the compounds according to formula (1-1), in various preferred embodiments, deposition via the gas phase in vacuum can be used, whereby the coordination compound can either undergo sublimation or evaporation and can be co-deposited with a second organic material, thereby forming mixed layers. The transfer into the gas phase can be further improved by using a carrier gas technology, whereby an inert gas that cannot be deposited into the organic layer comprising the coordination compound assists the sublimation or evaporation of the coordination compound. During the deposition process from gas phase, the coordination compound can be co-deposited with a second organic material using two separate thermal sources, in other words, a mixture is formed in-situ during deposition. During such co-deposition two or more additional materials can be deposited using a triple or quadruple evaporation, whereby the coordination compound according to the invention is further diluted. Alternatively, the metal-organic complex according to the invention can as well be thermally processed from one crucible. In other words, a mixture or a precursor thereof is already present before sublimation or evaporation. A precursor can for example be an additional auxiliary ligand present as part of the coordination compound that dissociates during thermal evaporation and that is substantially not built into the organic layer comprising the coordination compound according to the invention. Preferred in this situation are similar volatilities for the second organic material and the coordination compound. Alternatively, the coordination compound and the second organic material can form a frozen glass, thereby forcing the individual components to sublime at similar temperatures.

Given the high solubility of the compounds according to formula (1-1), a further preferred technique to fabricate organic layers including the coordination compound according to various embodiments can be deposition from a liquid phase using a mixture of or a single organic solvent, whereby the coordination compound according to various embodiments can be dissolved or forms a suspension within the organic solvent; in this description can be referred to as the ink. The ink using this deposition process can include a wide variety of other materials apart from the coordination compound according to various embodiments to allow fabrication of triple or higher-order mixed layers from solution. Additives within the ink can for example be, but may not be limited to, organic or inorganic materials capable of transporting charges, materials that improve the film formation, materials that improve the distribution of the coordination compound according to the invention within a third material, organic or inorganic materials that improve the efficiency of the device, e.g., by reducing the refractive index. The deposition from solution may not be limited to any specific technique. Examples of the deposition from solution include spin coating, casting, dip coating, gravure coating, bar coating, roll coating, spray coating, screen printing, flexographic printing, offset printing, inkjet printing.

Various post processing techniques can be applied to improve the performance or stability of the electroluminescent device. In one embodiment, some or all layers of the organic electronic device include functional groups capable of chemically crosslinking upon thermal or electromagnetic exposure, thereby forming larger covalently bound molecules with improved physical properties. In another embodiment functional groups are present in a second organic material, and after crosslinking the second organic material becomes a polymer with the coordination compound according to the invention being embedded into it. In yet another embodiment functional groups capable of crosslinking are present on both, the coordination compound and a second organic material, and after crosslinking, a single polymeric material covalently linking a second organic material with the metal-organic coordination compound according to the invention is formed.

For one or more aspects, at least one of the components set forth in one or more of the preceding figures can be configured to perform one or more operations, techniques, processes, and/or methods as set forth in the example section below. The examples set forth herein are illustrative and not exhaustive. Any of the examples can be combined with any other example (or combination of examples), unless explicitly stated otherwise. The foregoing description of one or more implementations provides illustration and description but is not intended to be exhaustive or to limit the scope of aspects to the precise form disclosed. Modifications and variations are possible in light of the above teachings or can be acquired from practice of various aspects. Any of the above-described embodiments can be combined with any (other) example as mentioned below (or combination of examples), unless explicitly stated otherwise.

### Examples

### 1. Synthesis of various coordination compounds

All experimental manipulations were carried out under an inert atmosphere. Tetrahydrofuran (Acros Organics, extra dry, AcroSeal) was dried and distilled from K/benzophenone or purchased as anhydrous from Acros Organics. Toluene (Acros Organics, Extra Dry, AcroSeal) purchased as anhydrous from Acros Organics, Methanol (Acros Organics, Extra Dry, AcroSeal) purchased as anhydrous from Acros Organics.

### 1.1 Synthesis of the ligand potassium tris(3,5-diethyl-1H-pyrazol-1-yl)boranuide

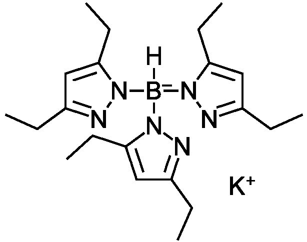

A mixture of 1.2 g freshly ground potassium borohydride (22.1 mmol, 1.0 eq.) and 9.6 g 3,5-diethylpyrazole (77.5 mmol, 3.5 eq.) is slowly heated up in a reflux setup under Nitrogen atmosphere up to 220 °C. After complete conversion the mixture is cooled to room temperature and evaporated to dryness. The product is purified through sublimation. Yield: 9.0 g (97%). ESI MS (MeOH, neg): 381 [M-K]⁺.

### 1.2 Synthesis of the ligand potassium 3,5-diethyl-1H-pyrazolate

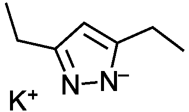

The synthesis is carried out under inert atmosphere. 4.6 g of 3,5-diethylpyrazole (36.9 g, 1.0 eq.) is dissolved in 100 mL dry toluene. 7.7 g of potassium hexamethyldisilazide (38.7 mmol, 1.1 eq.) is dissolved in 100 mL dry THF and added to the solution. After complete conversion the THF is removed in vacuo and the product precipitates in toluene. The solid is filtered off and washed with toluene and n-hexane and dried in vacuo. Yield: 5.5 g (93%).

### 1.3 Synthesis of Cerium 3,5-diethyl-1H-pyrazol-1-ide bis[tris(3,5-diethyl-1-pyrazolyl)boranuide] G5

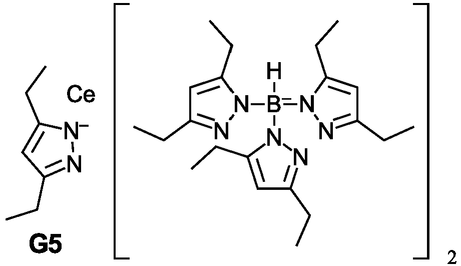

The reaction is carried out in a glovebox. 2.6 g of potassium tris(3,5-diethyl-1*H*-pyrazol-1-yl)boranuide (6.3 mmol, 2.0 eq.) is dissolved in 50 mL of dry THF. In a second solution 2.3 g of cerium(III) iodide (3.1 mmol, 1.0 eq.) is dissolved in 120 mL boiling THF and slowly added via syringe. It is followed by the addition of 0.5 g of potassium **3,5-diethyl-1***H*-pyrazol-1-ide (3.1 mmol, 1.0 eq.). The solution turns turbid upon addition. After 30 minutes THF is reduced to about 30 mL. 150 mL of toluene is added and the mixture is reduced again to 30 mL. The precipitate is filtered off and washed with toluene and n-hexane. The product is recrystallized in n-hexane and precipitated in the fridge overnight. The product is finally purified by sublimation. Yield: 2.3 g (36%). EA C₂₁H₃₄BKN₆; Calc.: C: 57.36%; H: 7.7%; N: 19.11%; found: C: 57.46%; H: 7.68%; N: 19.17%. XRD was done on individual crystals, which confirms the heteroleptic structure according to formula (1-1). XRD structural analysis from G5:

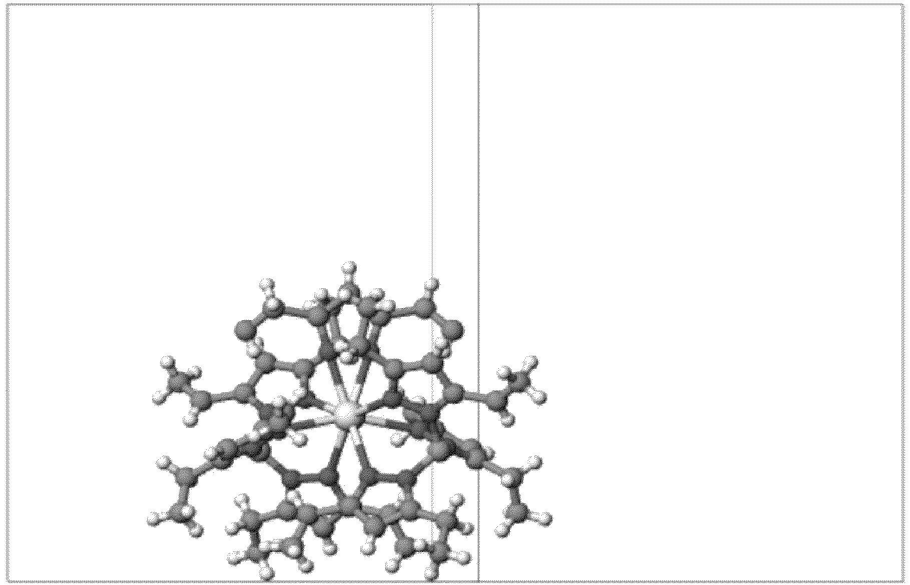

### 1.4 Synthesis of the ligand potassium 3,5-diphenyl-1H-pyrazol-1-ide

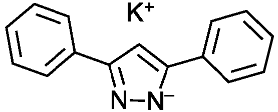

The reaction was performed in a glovebox. To 8.5 g of 3,5-diphenyl-1*H*-pyrazole (38.6 mmol, 1.0 eq.) in a mixture of 300 mL dry toluene/THF (1/2) was slowly added via syringe a mixture of 7.6 g of potassium hexamethyldisilazide (38.2 mmol, 1.0 eq.) in 100 mL dry THF. The reaction mixture is allowed to stir overnight. The solvents are reduced until the product precipitates. The solid is filtered off, washed with n-hexane and dried to completeness. Yield: 9.9 g (100%).

### 1.5 Synthesis of Cerium 3,5-diphenyl-1H-pyrazol-1-ide [tris(3,5-diethyl-1H-pyrazol-1-yl)boranuide]

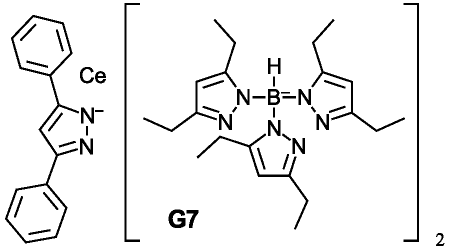

The reaction was carried out in a glovebox. In 30 mL of dry THF is dissolved 1.2 g of potassium tris(3,5-diethyl-1-pyrazolyl)boranuide (2.9 mmol, 2.0 eq.). After slow addition via syringe of 1.1 g of cerium(III) iodide (1.4 mmol, 1.0 eq.) dissolved in 60 mL of hot THF and a solution of 0.37 g of potassium 3,5-diphenyl-1*H*-pyrazol-1-ide (1.4 mmol, 1.0 eq.) in 50 mL dry THF is added. The turbid solution is stirred overnight. The solvent is removed completely, the solid is slurred up in n-hexane, filtered off and washed with n-hexane. The product is finally purified by sublimation. Yield: 0.3 g (19%). Analytic complies with desired structure. Analog to G5, XRD was done on individual crystals, which confirms the heteroleptic structure according to formula (1-1).

### 1.6 Synthesis of Gadolinium 3,5-diethyl-1H-pyrazol-1-ide bis[tris(3,5-diethyl-1-pyrazolyl)boranuide] G14

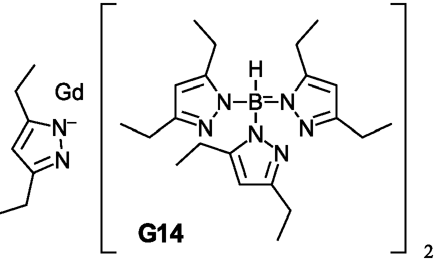

The reaction is carried out in a glovebox. 1.3 g of potassium tris(3,5-diethyl-1*H*-pyrazol-1-yl)boranuide (3.1 mmol, 2 eq.) is dissolved in 30 mL of dry THF. In a second solution 0.8 g of gadolinium(III) iodide (1.6 mmol, 1.0 eq.) is dissolved in 120 mL boiling THF and slowly added via syringe. 0.25 g of potassium 3,5-diethyl-1*H*-pyrazol-1-ide (1.6 mmol, 1.0 eq.) is dissolved in 20 mL dry THF and added to the mixture. The solution turns turbid upon addition. After 2 hours THF is reduced to about 30 mL. 150 mL of toluene is added and the mixture is reduced again to 30 mL. The precipitate is filtered off and washed with toluene and n-hexane. The product is recrystallized in n-hexane and precipitated in the fridge overnight. The product is finally purified by sublimation. Yield: 1.5 g (90%). EA C₂₈H₄₅BKN₈; Calc.: C: 56.42%; H: 7.63%; N: 18.80%; found: C: 56.54%; H: 7.66%; N: 18.86%.

### 1.7 Synthesis of comparative example 1 Cerium 3,5-dimethyl-1H-pyrazol-1-ide [tris(3,5-dimethyl-1H-pyrazol-1-yl)boranuide] CE-1

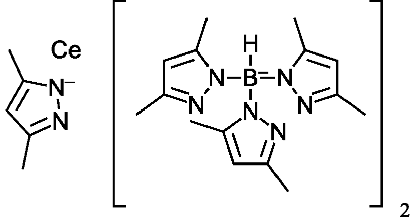

The product was synthesized according to the literature [1] a) Fang, P. et. al. ACS Appl. Mater. Interfaces 2021, 13, 45686-45695; b) Ortu, F. et. al. Inorganics 2015, 3(4), 534-553. Yield: 668 mg (95%). EA: C₃₅H₅₁CeB₃N₁₄; Calc.: C: 50.67%; H: 6.20%; N: 23.64%; found: C: 50.70%, H: 6.09%; N: 23.81%. Analytics according to the literature.

### 2. Device examples

Representative embodiments of organic electronic devices according to various embodiments will now be described, including a detailed description of the fabrication process of the organic electronic device. Yet, it will be understood that neither the specific techniques for fabrication of the device, nor the specific device layout, nor the specific compounds are intended to limit the scope of the present invention.

### Material definitions:

- ITO:: Indium tin oxide, transparent anode
- MoO3:: Molybdenum oxide
- Yb:: Ytterbium
- Al:: Aluminium
- Liq:: Lithium 8-quinolinolate
- H1:: [3-(9-Carbazolyl)-9-oxa-1-fluorenyl]tris(phenyl)silane
- H2:: Bis[3,5-di(9H-carbazol-9-yl)phenyl]diphenylsilane
- H3:: 2-Phenyl-4,6-bis(3-(triphenylsilyl)phenyl)-1,3,5-triazine
- H4:: 1,3-Bis(9-phenyl-1,10-phenanthrolin-2-yl)benzene
- H5:: 4-[(Z)-{(Z)-2,3-Bis[cyano(4-cyano-2,3,5,6-tetrafluorophenyl)methylene]cyclopropylidene}cyanomethyl]-2,3,5,6-tetrafluorobenzonitrile
- H6:: N-[1,1'-Biphenyl]-2-yl-N-(9,9-dimethyl-9H-fluoren-2-yl)-9,9'-spirobi[9H-fluoren]-2-amine

The materials MoO3, Yb, Liq, Al, H1, H2, H3, H4, H6 are commercially available. H1, H2, H3, H4, H6 were purchased from Jilin OLED Material Tech Co.,Ltd., and from Shenzhen Puri Materials Technology Co., Ltd. The materials were purified by sublimation prior use.

### Examples and comparative examples (electroluminescent devices) processed

The organic electronic devices were prepared with the following generic layer sequences:
**Film Device 1:**
   Quartz / 45:5 nm H1:G5
**Film Device 2:**
   Quartz / 45:5 nm H1:CE-1
**Device A:**
   ITO / 9.7:0.3 nm H6:H5 / 20 nm H6 / 10 nm G5 / 29.1:0.9 nm H6:H5 / 1 nm H5 / 120 nm Al.
**Device B:**
   ITO / 9.7:0.3 nm H6:H5 / 20 nm H6 / 10 nm CE-1 / 29.1:0.9 nm H6:H5 / 1 nm H5 / 120 nm Al.
**Device C:**
   ITO / 29.7:0.3 nm H4:Yb / 10 nm G5 / 29.7:0.3 nm H4:Yb / 120 nm Al.
**Device D:**
   ITO / 29.7:0.3 nm H4:Yb / 10 nm CE-1 / 29.7:0.3 nm H4:Yb / 120 nm Al.
**Device E:**
   ITO / 2 nm MoO3 / 65 nm H2 / 5 nm H1 / 2 nm G5 / 5 nm H3 / 34:34 nm H3:Liq /120 nm Al.
**Device F:**
   ITO / 2 nm MoO3 / 65 nm H2 / 5 nm H1 / 2 nm CE-1 / 5 nm H3 / 34:34 nm H3:Liq / 120 nm Al.
**Device G:**
   ITO / 2 nm MoO3 / 65 nm H2 / 5 nm H1 / 5 nm G5 / 5 nm H3 / 34:34 nm H3:Liq /120 nm Al.
**Device H:**
   ITO / 2 nm MoO3 / 65 nm H2 / 5 nm H1 / 5 nm CE-1 / 5 nm H3 / 34:34 nm H3:Liq / 120 nm Al.
**Device I:**
   ITO / 2 nm MoO3 / 65 nm H2 / 5 nm H1 / 31.5:3.5 nm H3:G5 / 5 nm H3 / 17.5:17.5 nm H3:Liq / 120 nm Al.
**Device J:**
   ITO / 2 nm MoO3 / 65 nm H2 / 5 nm H1 / 21:9.45:4.55 nm H3:CE-1 / 5 nm H3 / 17.5:17.5 nm H3:Liq / 120 nm Al.

Both film devices 1 and 2 were fabricated on pre-cleaned 1"x1 " quartz substrates. Every other device was fabricated on a 1"x1" size glass substrate, pre-coated with a transparent ITO anode and a pixel definition layer (Geomatec). The substrates were loaded into an ultrahigh vacuum evaporation tool operating at around 10⁻⁷ mbar pressure. N2 plasma treatment was carried out on the substrates in a separate vacuum chamber prior organic layer deposition. The organic layers were deposited onto the substrate in the sequence stated above. In the case of more than one material present in the layer, the layer is homogeneously mixed using a simultaneous co-evaporation, with the intended mixing ratio achieved by setting the evaporation rates of each material accordingly.

The organic electronic devices, except for the film devices, were finished by evaporating a 120 nm film of cathode Al. The AI deposition was carried out using a structured shadow mask, such that the resulting overlap of pre-structured ITO, organic layers and AI gave an active area of 3.88 mm2. Subsequently, the finished devices were transferred to a nitrogen atmosphere glovebox and encapsulated by gluing an additional encapsulating glass substrate on top to prevent oxygen- and water-induced degradation. A liquid getter is dispensed onto the encapsulating glass substrate which absorbs moisture. The electrical and electroluminescent properties of the device were measured using an integrated OLED characterization setup M7000 (McScience inc.). The film devices were measured using a spectrometer HORIBA Fluoromax 4P.

### Device results:

Various devices exemplifying the invention are described in detail below. Devices containing G5 are considered examples according to invention, while comparative examples are devices containing CE-1.

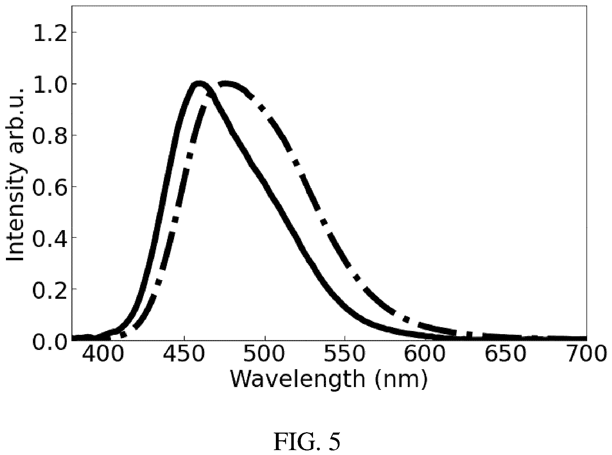

For applications in OLED, it is relevant to evaluate the emission properties of luminescent complexes, namely, the peak wavelength of the luminescence spectrum and the width of the luminescence spectrum, represented by the full width at half maximum (FWHM). Generally, for display applications, pure colors, i.e. narrow emission spectra are more desirable. To probe these emission properties, it is beneficial to create thin film devices wherein the complex investigated is doped (mixed) into an organic host, in this case H1, at low concentrations. Both samples were measured by exciting the complex selectively, without exciting the host material, thus the emission arising from film devices 1 and 2 originate in the complexes G5 and CE-1, exclusively. Considering **Fig. 5****,** where the emission spectra of film devices 1 and 2 (featuring complexes G5 and CE-1, respectively) are displayed, it is evident that 1 (solid line) features both narrower and blue-shifted emission compared to 2 (dash-dotted line). Both complexes feature a similar chemical composition in that they both are cerium-containing materials with substituted tris-pyrazolyl borate anions. G5 has ethyl-substituted pyrazolyl, while CE-1 has methyl-substituted pyrazolyl. The ethyl substitution here can contribute to different intermolecular spacing and packing of the complex in the thin film, such that the emission properties of G5 become favorable, namely, blue-shifted and narrower. Table 1 below summarizes the relevant photoluminescence parameters - peak wavelength and FWHM for the two complexes compared.

**Table 1. Peak wavelength and FWHM of the film devices 1 and 2**

| | Use | PL peak, nm | FWHM, nm |
|---|---|---|---|
| Film Device 1 | Example according to invention | 458 | 76 |
| Film Device 2 | Comparative example | 474 | 86 |

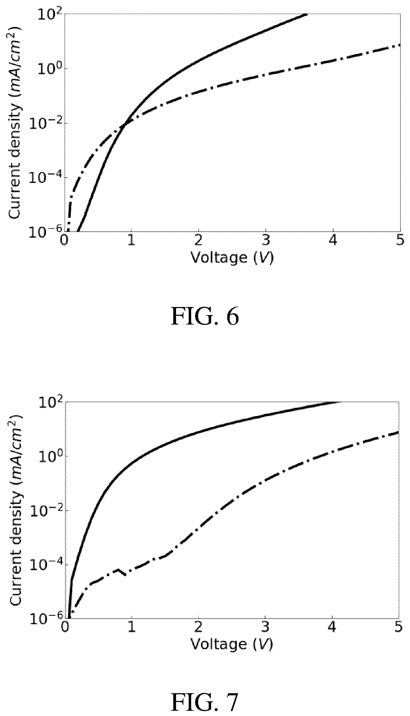

Another aspect, important for the design of electroluminescent devices, in which the investigated complexes can be compared is their ability for conducting electrical charges. Simple single-carrier devices, such as defined in devices A-D, allow exclusively for hole currents (devices A, B) or electron currents (devices C, D). The devices were designed in a way that they feature only the layers required for efficient carrier injection and transport from the electrodes, plus a pure layer of the coordination compound under investigation. **Fig. 6** shows the current-voltage (IV) characteristics of the hole-only devices (HODs). Clearly evident from the graph, the current is significantly higher for device A (solid line) compared to device B (dash-dotted line) at voltages higher than 1 V. **Fig. 7** shows the current-voltage (IV) characteristics of the electron-only devices (EODs). It is seen that the current is significantly higher for device C (solid line) compared to device D (dash-dotted line) in the whole measured voltage range. Despite device B showing higher currents at low voltages (0-1 V), it can be concluded that device A is superior to device B, and device C is superior to device D, because typical current densities required for organic electronic device operation are 0.1 to 10 mA/cm² and in this range, the driving voltages, are lower for devices A, C (containing G5), compared to devices B, D (containing CE-1). In other words, devices according to the invention A, and C require lower driving voltages to pass a certain electron or hole current and thus feature a higher electron and hole mobility. Because of the straightforward device design, it is therefore concluded that the differences in IV characteristics measured in the devices arise directly from different charge transporting properties of the two complexes compared. G5 shows higher currents in both HOD and EOD and is therefore superior to CE-1. Table 2 below summarizes the relevant voltages at fixed current densities of 1.0, 3.3, and 10.0 mA/cm2. It is seen that devices A and C, containing the complex G5, require significantly lower voltages to drive the cited current density values, compared to devices B and D, respectively.

**Table 2. Voltage values at given current densities of 1.0 mA/cm², 3.3 mA/cm², 10.0 mA/cm² for devices A-D**

| | Use | V at 1 mA/cm², V | V at 3.3 mA/cm², V | V at 10 mA/cm², V |
|---|---|---|---|---|
| Device A | Example according to invention | 1.81 | 2.2 | 2.6 |
| Device B | Comparative example | 3.45 | 4.43 | 5.2 |
| Device C | Example according to invention | 1.16 | 1.6 | 2.2 |
| Device D | Comparative example | 3.83 | 4.47 | 5.2 |

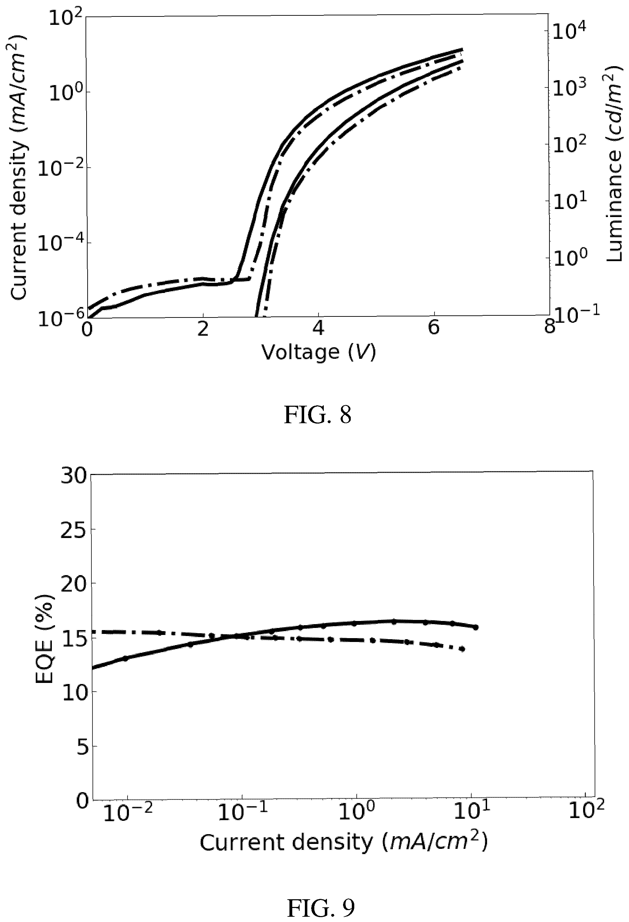

Devices E, F, G, H are designed in the way that allows for screening the complexes electroluminescent properties without using an organic host material. The devices E and F feature a 2 nm emissive interlayer and devices G and H feature a 5 nm emissive interlayer, where the material used in the interlayer is the compound under investigation. The only difference between the device pairs E, F and G, H is therefore the choice of the emissive material, otherwise the devices are identical. The devices emit in the deep blue spectral region. In **Fig. 8 and 9** current-voltage-luminance (IVL) and external quantum efficiency (EQE) characteristics, respectively, comparing the two devices E and F are depicted. Here, solid lines are used for the example according to invention, device E, using G5 as emitting layer, while dash-dotted lines are used for comparative device F, employing the structurally very similar CE-1 as the emissive layer. From Fig. 8 it is evident that the device according to the invention, E, shows higher currents (left axis) and more light output (right axis) at a fixed voltage compared to the device F. In Fig. 9 the corresponding external quantum efficiencies (EQEs) of the two devices are plotted against current density. The higher current and light output of the device according to the invention equates to a different shape of the EQE curve, showing higher values at the current densities > 0.1 mA/cm2. Furthermore, device E shows a blue-shifted emission compared to device F, as is the case in the Film devices 1 and 2 compared above, because the electroluminescence seen in devices E and F arises from the same emission process as it does in the photoluminescence measured in Film devices 1 and 2. The emission properties, specifically, the emission spectrum and the FWHM are maintained in device under electrical excitation. Device E using the complex G5 is superior in all three aspects compared in Table 3 below: it shows a lower driving voltage, higher EQE and blue-shifted spectrum compared to device F, featuring CE-1. Given the higher external quantum efficiency combined with lower driving voltage translates into a significantly improved power efficiency for the device according to the invention, E, compared to the comparative example, F. The difference between G5 and CE-1 when used as emissive interlayer is even larger when the interlayer is made thicker. Devices G and H employ 5 nm of emissive interlayer, and it is seen that device G, containing the complex G5, is superior to device H in all aspects compared in Table 3. Devices E and G show nearly identical performance, where G5 is used as emissive interlayer with 2 nm and 5 nm, respectively. This is in stark contrast to devices F and H, wherein CE-1 is used as emissive interlayer with 2 nm and 5 nm, respectively. It is seen that device H, featuring a thicker interlayer, shows increased voltage and reduced EQE compared to its counterpart device F. The reason behind the evident difference is the previously discussed favorable charge transport characteristics of G5, which allows for the use of a thicker interlayer without compromising performance. CE-1, on the other hand, showed poor charge transport characteristics and this is seen in the worse performance of the device H.

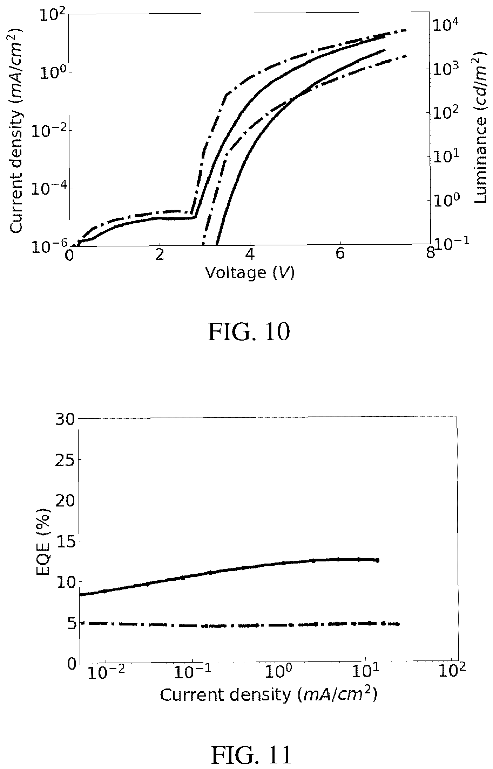

In OLED, the emissive material typically is inserted into an organic host material, such that the function of the complex is limited solely to light generation, while charge transport and recombination is undertaken by one or more host materials. Devices I and J exemplify such case, where the emitters are doped at low concentrations into host materials capable of transporting electrical charges. The choice of the emitting compound is the only difference between the two devices I and J. Comparing the IVL characteristics of devices I (G5, solid line) and J (CE-1, dash-dotted line) in **Fig. 10****,** it is seen that device I shows lower currents in the whole measured voltage range (left axis), but higher light output at voltages >4.5 V (right axis). Furthermore, it is seen that the current level becomes the same for both devices I and J at high voltages ~ 7 V. Without evoking any elaborate theories, the different shapes of the IV curves likely stems from differences in charge transport in the emitting layers, arising from different charge transporting behavior of the two complexes, as discussed above. Particularly, there might be a complicated interplay between mobility on the emitting material versus charge trapping on the emitting material embedded inside the host. Nevertheless, comparing the V-L curves specifically (right axis) it is seen that the solid curve, representing device according to the invention, I, containing complex G5, is superior - steeper and reaching higher luminance values. Thus, comparing external quantum efficiency (EQE) curves plotted over current density of devices I (solid line) and J (dash-dotted line) in **Fig. 11****,** it is obvious that device I has significantly higher EQE values in the whole measured range. Comparing the emission spectra of devices I and J, it is seen that device I, containing complex G5, maintains its blue-shifted emission, as seen in devices E and F as well as the thin film devices 1 and 2. In Table 3 the most relevant device parameters of Devices E to J are tabulated at constant current densities namely voltage, EQE and EL spectral peak values at current density of 3.3 mA/cm².

**Table 3. Voltage, EQE and EL spectral peak values at a given current density of 3.3 mA/cm² for devices E to J**

| Device | Use | V at 3.3 mA/cm², V | EQE at 3.3 mA/cm², % | El peak, nm |
|---|---|---|---|---|
| E | Example according to invention | 4.8 | 17.6 | 458 |
| F | Comparative example | 5.5 | 14.3 | 474 |
| G | Example according to invention | 5 | 17.6 | 458 |
| H | Comparative example | 5.8 | 9.9 | 474 |
| I | Example according to invention | 5.6 | 13 | 466 |
| J | Comparative example | 5.2 | 4 | 472 |

The present invention is further illustrated by the following first set of embodiments and combinations of embodiments resulting from the dependencies and back-references as indicated. In particular, it is noted that in each instance where a range of embodiments is mentioned, for example in the context of a term such as "The process of any one of embodiments 1 to 4", every embodiment in this range is meant to be explicitly disclosed for the skilled person, i.e. the wording of this term is to be understood by the skilled person as being synonymous to "The process of any one of embodiments 1, 2, 3 and 4". Further, it is explicitly noted that the following set of embodiments represents a suitably structured part of the general description directed to preferred aspects of the present invention, and, thus, suitably supports, but does not represent the claims of the present invention.

The following are preferred embodiments of the invention. The respective features can be freely combined with each other without departing from the present invention.
1. An organic electroluminescent device comprising:
   a first electrode,
   a second electrode, and
   an organic layer disposed between the first electrode and the second electrode,
   the organic layer comprising at least one charge-neutral metal-organic coordination compound of general formula (1-1): 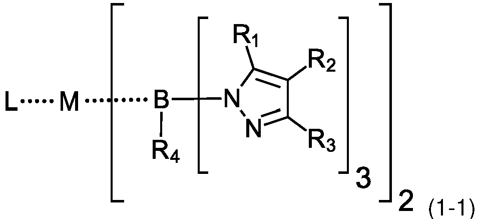 with
      - M being Gd(III) or Ce(III),
      - 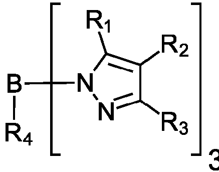 independently representing each a singly electrically negatively charged ligand with
      - **R₁** and **R₃** being independently, preferably identical in each occurrence, selected from organyl groups having at least 6 atoms, and
      - **R₂** and **R₄** being independently, preferably identical in each occurrence, selected from the group consisting of hydrogen, deuterium, fluorine, nitrile, and an organyl group, and with
      - L representing a singly electrically negatively charged ligand, and
      - **broken lines** indicating coordinative and/or ionic bonds.
2. The electroluminescent device of embodiment 1, with **R₁** and **R₃** in each instance being independently, preferably identical in each occurrence, selected from the group consisting of a substituted or non-substituted aryl, preferably phenyl, a substituted or non-substituted heteroalkyl, and a substituted or non-substituted alkyl, preferably ethyl, most preferably **R₁** and **R₃** being ethyl.
3. The electroluminescent device of embodiment 1 or 2, with **R₄** being hydrogen, deuterium, fluorine, nitrile, a linear or branched heteroalkyl or a linear or branched alkyl, preferably with **R₄** being selected from the group consisting of methyl, ethyl, iso-propyl, n-propyl tert-butyl, isobutyl, and n-butyl, or with **R₄** being a substituted or non-substituted aryl or a substituted or non-substituted heteroaryl, preferably with **R₄** being selected from the group consisting of phenyl, pyridyl, pyrazolyl, triazolyl, and imidazolyl.
4. The electroluminescent device of one of embodiments 1 to 3, with **R₂** being selected from the group consisting of hydrogen, deuterium, methyl, ethyl, and n-propyl.
5. The electroluminescent device of one of embodiments 1 to 4, with **L** being a singly electrically negatively charged substituted or non-substituted heterocycle, preferably the heterocycle being selected from the group consisting of imidazolyl, pyrazolyl, 1,2,3-triazolyl, 1,2,4-triazoyl, and benzimidazolyl, with the optional substituents preferably being selected from the group consisting of methyl, ethyl, isopropyl, n-propyl, tert-butyl, isobutyl, n-butyl, phenyl, and mesityl.
6. The electroluminescent device of one of embodiments 1 to 5, with L being a singly electrically negatively charged pyrazolyl that is di-substituted in the 3,5-positions with identical substituents.
7. The electroluminescent device of one of embodiments 1 to 6, with the charge-neutral metal-organic coordination compound of general formula (1-1) being a charge-neutral metal-organic coordination compound of general formula (1-2): 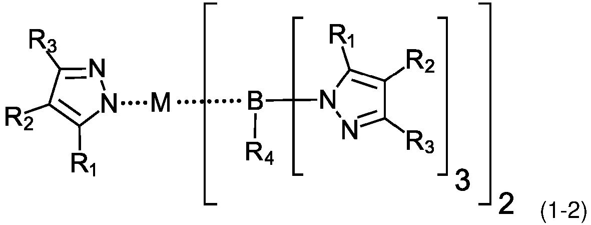 with 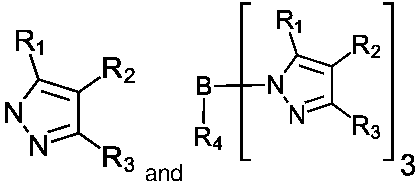 independently representing each a singly electrically negatively charged ligand, with **R₁** to **R₄** being independently, preferably identical in each occurrence, as defined in one of embodiments 1 to 4, the broken lines and **M** being as defined in embodiment 1.
8. The electroluminescent device of one of embodiments 1 to 7, with the charge-neutral metal-organic coordination compound of general formula (1-1) being selected from G1 to G18: 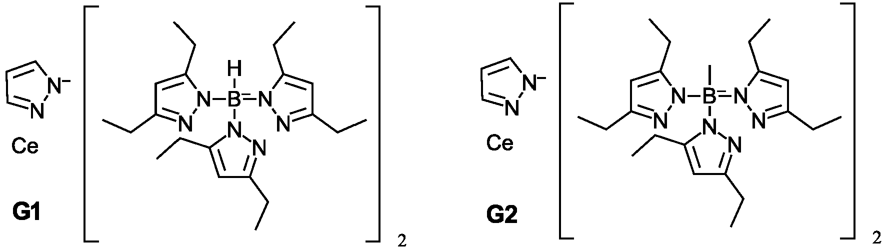 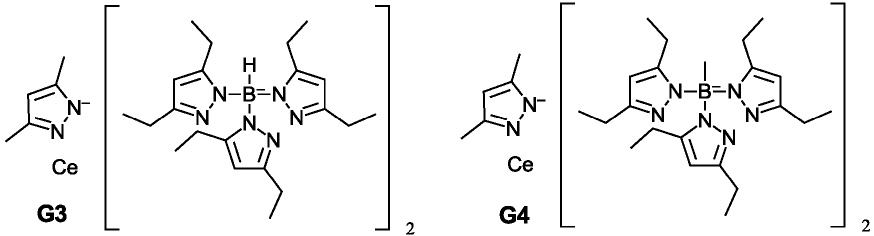 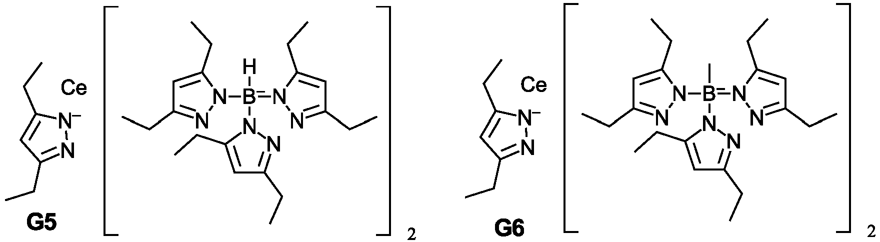 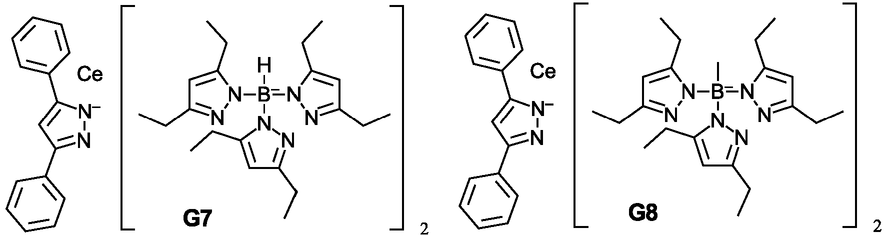 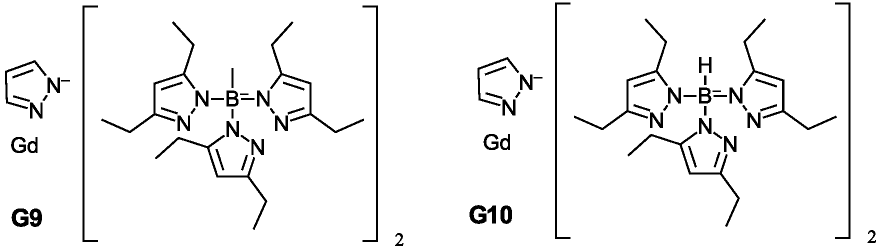 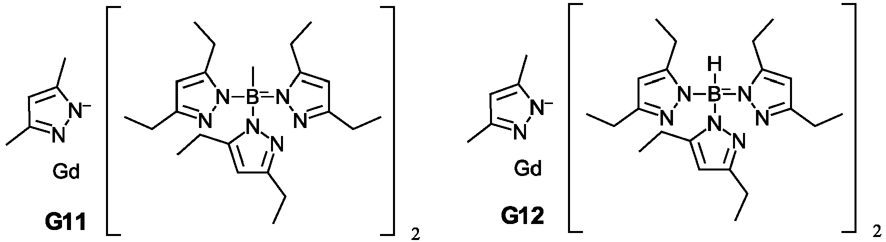 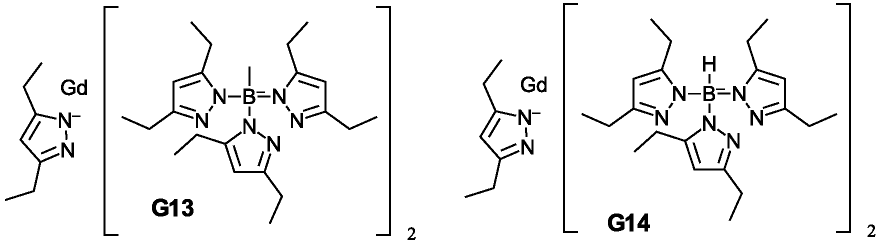 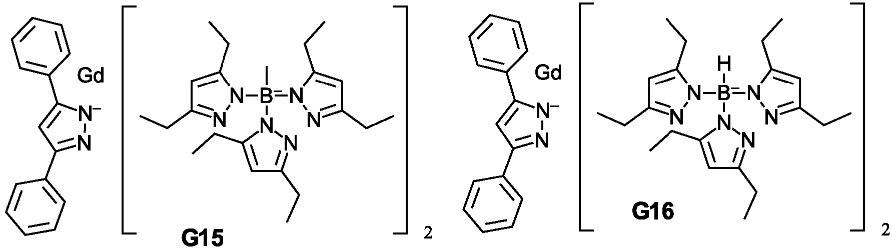 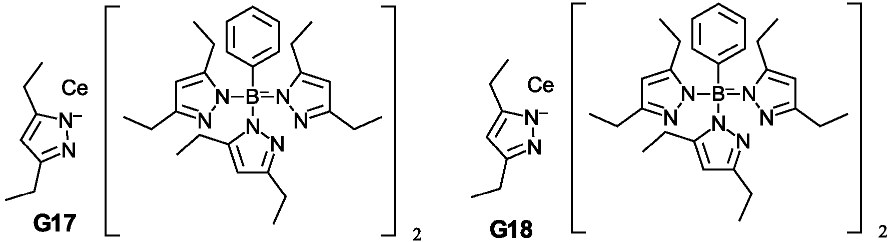
9. The electroluminescent device according to one of embodiments 1 to 8, with the organic layer disposed between the first electrode and the second electrode additionally comprising at least one phosphorescent light emitting material which preferably emits substantially in the blue spectral region and/or preferably comprises a metal cation selected from Pt(II) and Ir(III).
10. The electroluminescent device according to one of embodiments 1 to 9, with the organic layer disposed between the first electrode and the second electrode additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.
11. The electroluminescent device according to one of embodiments 1 to 10, with the organic layer disposed between the first electrode and the second electrode comprising the metal organic coordination compound according to general formula (1-1) being configured as a hole transporting layer, wherein preferably the hole transporting layer is located adjacent to one of the electrodes, preferably the anode, or not being in contact with any of the electrodes, preferably as part of a charge generation layer.
12. The electroluminescent device according to embodiment 11, with the hole transport layer substantially only comprising the metal organic coordination compound of general formula (1-1) or comprising the metal organic coordination compound of general formula (1-1) mixed with one or more additional materials, preferably at least one redox dopant capable of generating free holes.
13. A process for preparing the electroluminescent device according to one of embodiments 1 to 12, wherein the metal organic coordination compound of general formula (1-1) is deposited from a gas phase, preferably using an evaporation and/or sublimation and/or carrier gas process, or is deposited from solution.
14. A metal organic coordination compound of general formula (1-1) as defined in one of embodiments 1 to 8.
15. The metal organic coordination compound according to embodiment 14, with the charge-neutral metal-organic coordination compound of general formula (1-1) being a charge-neutral metal-organic coordination compound of general formula (1-2), or with the charge-neutral metal-organic coordination compound of general formula (1-1) being selected from G1 to G18.
16. The electroluminescent device according to one of embodiments 1 to 12, wherein the device is an OLED display device.
17. The electroluminescent device according to embodiments 16, wherein the OLED display device is part of a TV set, laptop computer, smartphone, tablet, monitor or display device, containing the electroluminescent device according to one of embodiments 1 to 12.
18. The use of at least one charge-neutral metal-organic coordination compound of general formula (1-1) as defined in one of embodiments 1 to 8 in organic emission layers of electroluminescent devices.
19. A mixture comprising at least one charge-neutral metal-organic coordination compound of general formula (1-1) as defined in one of embodiments 1 to 8, and additionally comprising at least one phosphorescent light emitting material which preferably emits substantially in the blue spectral region and/or comprises a metal cation selected from Pt(II) and Ir(III), and preferably additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.
20. A TV set, laptop computer, smartphone, tablet, monitor or display device, containing an electroluminescent device according to one of embodiments 1 to 12, a charge-neutral metal-organic coordination compound according to one of embodiments 11 to 8, a mixture as defined in embodiment 21 or a mixture as defined in embodiment 22.
21. The use of a singly electrically negatively charged ligand of general formula 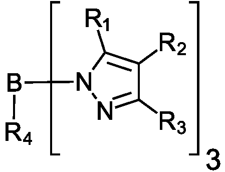 with
   - R₁ and R₃ being independently, preferably identical in each occurrence, selected from organyl groups having at least 6 atoms, and
   - R₂ and R₄ being independently, preferably identical in each occurrence, selected from the group consisting of hydrogen, deuterium, fluorine, nitrile, and an organyl group,
   in charge-neutral metal-organic coordination compounds.

## Claims

1. An organic electroluminescent device comprising:
a first electrode,
a second electrode, and
an organic layer disposed between the first electrode and the second electrode,
the organic layer comprising at least one charge-neutral metal-organic coordination compound of general formula (1-1): 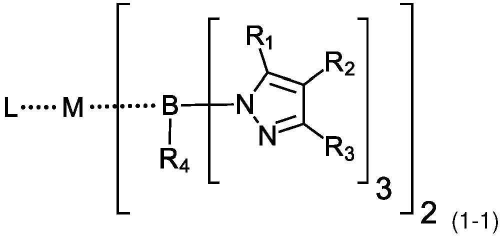 with
• M being Gd(III) or Ce(III),
• 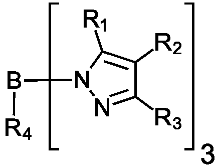 independently representing each a singly electrically negatively charged ligand with
• **R₁** and **R₃** being independently, preferably identical in each occurrence, selected from organyl groups having at least 6 atoms, and
• **R₂** and **R₄** being independently, preferably identical in each occurrence, selected from the group consisting of hydrogen, deuterium, fluorine, nitrile, and an organyl group, and with
• **L** representing a singly electrically negatively charged ligand, and
• **broken lines** indicating coordinative and/or ionic bonds.

2. The electroluminescent device of claim 1, with **R₁** and **R₃** in each instance being independently, preferably identical in each occurrence, selected from the group consisting of a substituted or non-substituted aryl, preferably phenyl, a substituted or non-substituted heteroalkyl, and a substituted or non-substituted alkyl, preferably ethyl, most preferably **R₁** and **R₃** being ethyl.

3. The electroluminescent device of claim 1 or 2, with **R₄** being hydrogen, deuterium, fluorine, nitrile, a linear or branched heteroalkyl or a linear or branched alkyl, preferably with **R₄** being selected from the group consisting of methyl, ethyl, iso-propyl, n-propyl tert-butyl, isobutyl, and n-butyl, or with **R₄** being a substituted or non-substituted aryl or a substituted or non-substituted heteroaryl, preferably with **R₄** being selected from the group consisting of phenyl, pyridyl, pyrazolyl, triazolyl, and imidazolyl.

4. The electroluminescent device of one of claims 1 to 3, with **R₂** being selected from the group consisting of hydrogen, deuterium, methyl, ethyl, and n-propyl.

5. The electroluminescent device of one of claims 1 to 4, with **L** being a singly electrically negatively charged substituted or non-substituted heterocycle, preferably the heterocycle being selected from the group consisting of imidazolyl, pyrazolyl, 1,2,3-triazolyl, 1,2,4-triazoyl, and benzimidazolyl, with the optional substituents preferably being selected from the group consisting of methyl, ethyl, isopropyl, n-propyl, tert-butyl, isobutyl, n-butyl, phenyl, and mesityl.

6. The electroluminescent device of one of claims 1 to 5, with L being a singly electrically negatively charged pyrazolyl that is di-substituted in the 3,5-positions with identical substituents.

7. The electroluminescent device of one of claims 1 to 6, with the charge-neutral metal-organic coordination compound of general formula (1-1) being a charge-neutral metal-organic coordination compound of general formula (1-2): 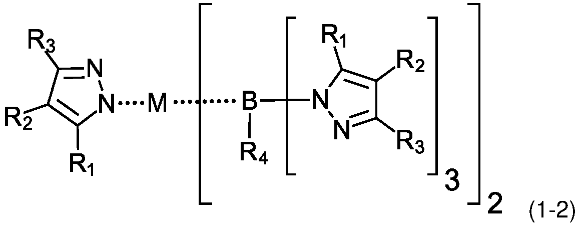 with 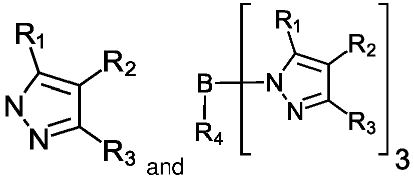 independently representing each a singly electrically negatively charged ligand, with **R₁** to **R₄** being independently, preferably identical in each occurrence, as defined in one of claims 1 to 4, the broken lines and **M** being as defined in claim 1.

8. The electroluminescent device of one of claims 1 to 7, with the charge-neutral metal-organic coordination compound of general formula (1-1) being selected from G1 to G18:

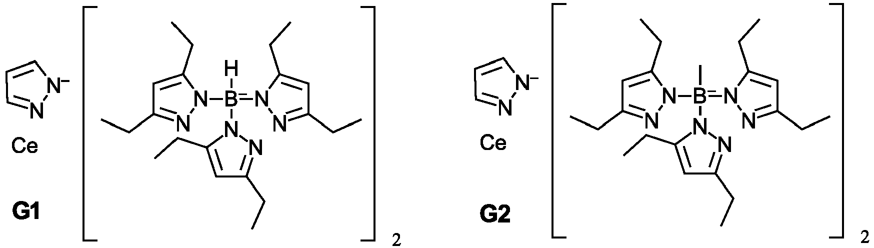

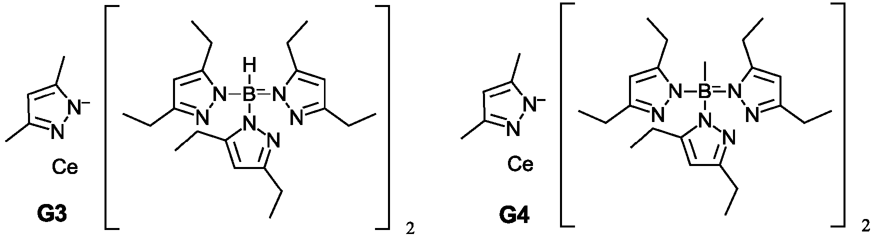

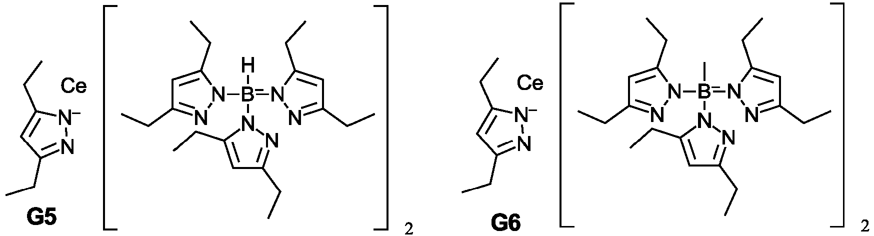

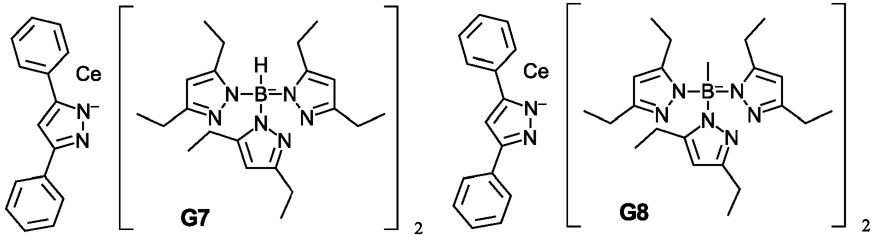

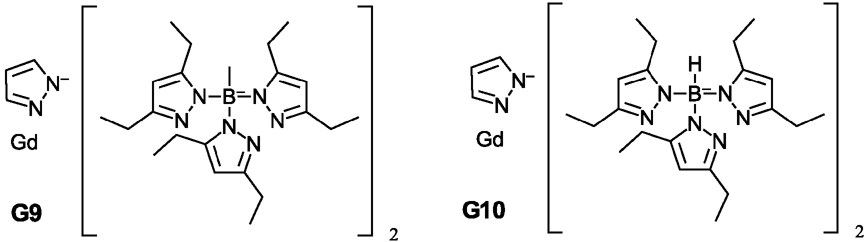

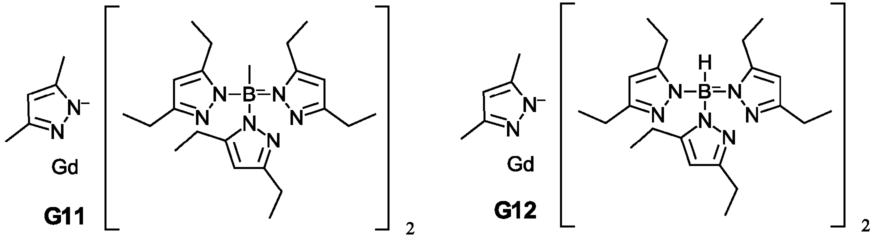

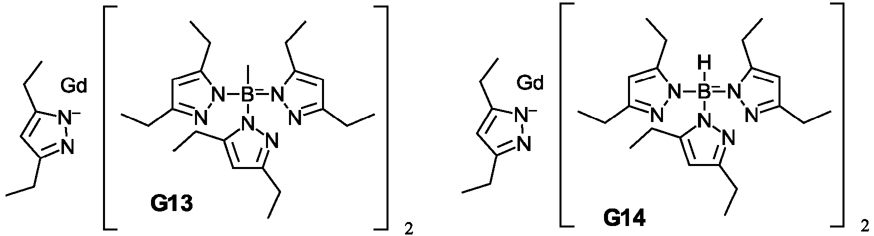

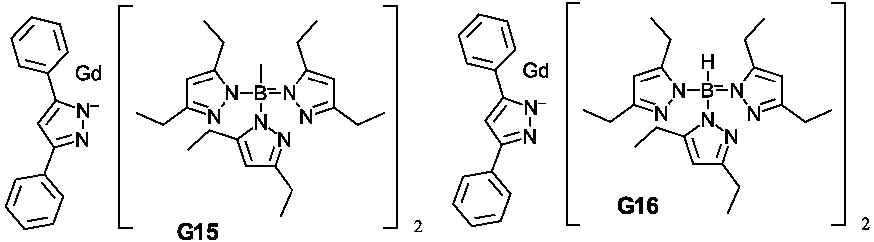

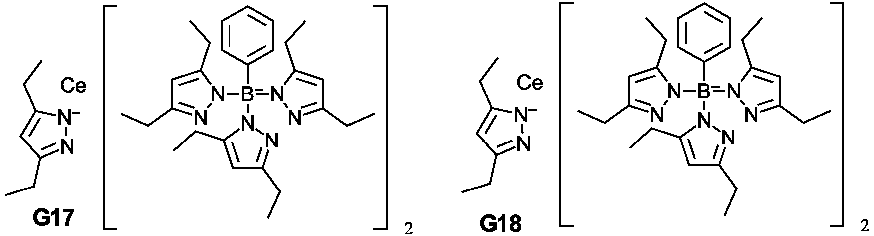

9. The electroluminescent device of one of claims 1 to 8, with the organic layer disposed between the first electrode and the second electrode additionally comprising at least one phosphorescent light emitting material which preferably emits substantially in the blue spectral region and/or preferably comprises a metal cation selected from Pt(II) and Ir(III).

10. The electroluminescent device of one of claims 1 to 9, with the organic layer disposed between the first electrode and the second electrode additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.

11. The electroluminescent device of one of claims 1 to 10, with the organic layer disposed between the first electrode and the second electrode comprising the metal organic coordination compound according to general formula (1-1) being configured as a hole transporting layer, wherein preferably the hole transporting layer is located adjacent to one of the electrodes, preferably the anode, or not being in contact with any of the electrodes, preferably as part of a charge generation layer.

12. The electroluminescent device of claim 11, with the hole transport layer substantially only comprising the metal organic coordination compound of general formula (1-1) or comprising the metal organic coordination compound of general formula (1-1) mixed with one or more additional materials, preferably at least one redox dopant capable of generating free holes.

13. A process for preparing the electroluminescent device according to one of claims 1 to 12, wherein the metal organic coordination compound of general formula (1-1) is deposited from a gas phase, preferably using an evaporation and/or sublimation and/or carrier gas process, or is deposited from solution.

14. A metal organic coordination compound of general formula (1-1) as defined in one of claims 1 to 8.

## Amended claims

### Amended claims in accordance with Rule 137(2) EPC.

1. An organic electroluminescent device (100) comprising:
a first electrode (104),
a second electrode (108), and
an organic layer (106) disposed between the first electrode and the second electrode (104, 108),
**characterized in that** the organic layer (106) comprises at least one charge-neutral metal-organic coordination compound of general formula (1-1): 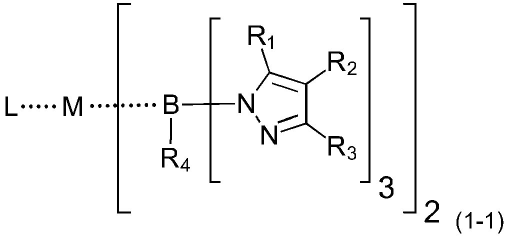
with
• **M** being Gd(III) or Ce(III), 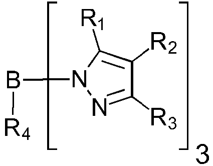 independently representing each a singly electrically negatively charged ligand with
• **R₁** and **R₃** being independently, preferably identical in each occurrence, selected from organyl groups having at least 6 atoms, and
• **R₂** and **R₄** being independently, preferably identical in each occurrence, selected from the group consisting of hydrogen, deuterium, fluorine, nitrile, and an organyl group, and with
• **L** representing a singly electrically negatively charged ligand, and
• **broken lines** indicating coordinative and/or ionic bonds.

2. The electroluminescent device (100) of claim 1, with **R₁** and **R₃** in each instance being independently, preferably identical in each occurrence, selected from the group consisting of a substituted or non-substituted aryl, preferably phenyl, a substituted or non-substituted heteroalkyl, and a substituted or non-substituted alkyl, preferably ethyl, most preferably **R₁** and **R₃** being ethyl.

3. The electroluminescent device (100) of claim 1 or 2, with **R₄** being hydrogen, deuterium, fluorine, nitrile, a linear or branched heteroalkyl or a linear or branched alkyl, preferably with **R₄** being selected from the group consisting of methyl, ethyl, isopropyl, n-propyl tert-butyl, isobutyl, and n-butyl, or with **R₄** being a substituted or non-substituted aryl or a substituted or non-substituted heteroaryl, preferably with **R₄** being selected from the group consisting of phenyl, pyridyl, pyrazolyl, triazolyl, and imidazolyl.

4. The electroluminescent device (100) of one of claims 1 to 3, with **R₂** being selected from the group consisting of hydrogen, deuterium, methyl, ethyl, and n-propyl.

5. The electroluminescent device (100) of one of claims 1 to 4, with L being a singly electrically negatively charged substituted or non-substituted heterocycle, preferably the heterocycle being selected from the group consisting of imidazolyl, pyrazolyl, 1,2,3-triazolyl, 1,2,4-triazoyl, and benzimidazolyl, with the optional substituents preferably being selected from the group consisting of methyl, ethyl, isopropyl, n-propyl, tert-butyl, isobutyl, n-butyl, phenyl, and mesityl.

6. The electroluminescent device (100) of one of claims 1 to 5, with L being a singly electrically negatively charged pyrazolyl that is di-substituted in the 3,5-positions with identical substituents.

7. The electroluminescent device (100) of one of claims 1 to 6, with the charge-neutral metal-organic coordination compound of general formula (1-1) being a charge-neutral metal-organic coordination compound of general formula (1-2): 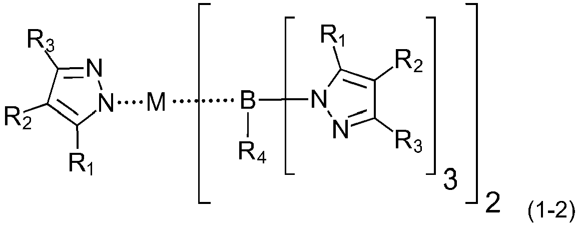 with 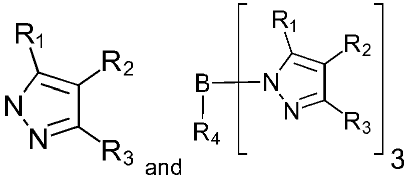 independently representing each a singly electrically negatively charged ligand, with **R₁** to **R₄** being independently, preferably identical in each occurrence, as defined in one of claims 1 to 4, the broken lines and **M** being as defined in claim 1.

8. The electroluminescent device (100) of one of claims 1 to 7, with the charge-neutral metal-organic coordination compound of general formula (1-1) being selected from G1 to G18:

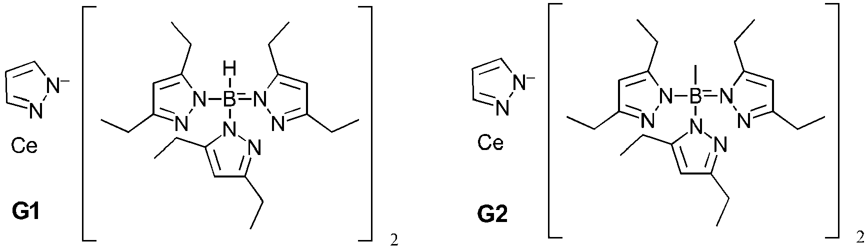

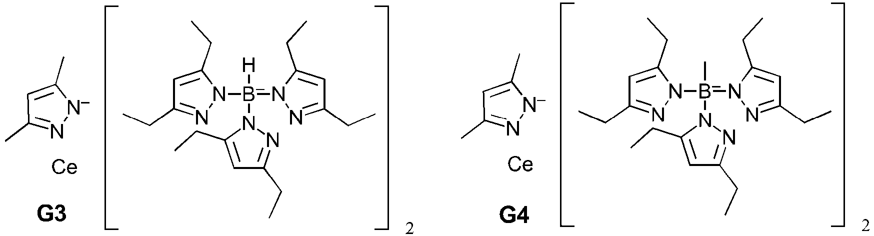

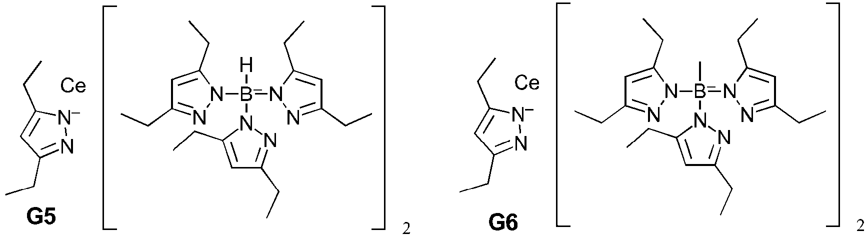

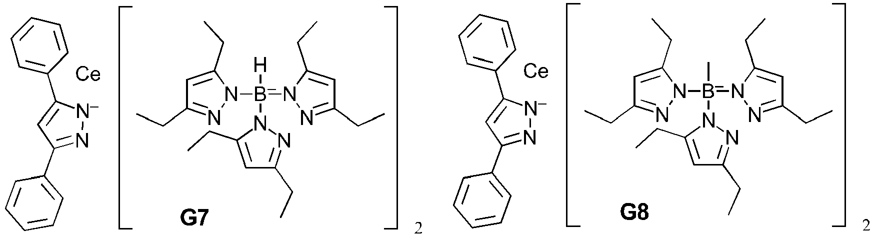

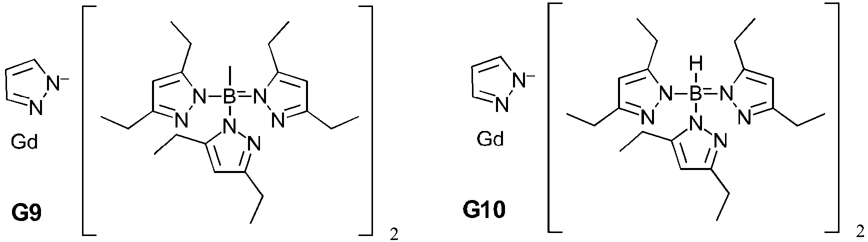

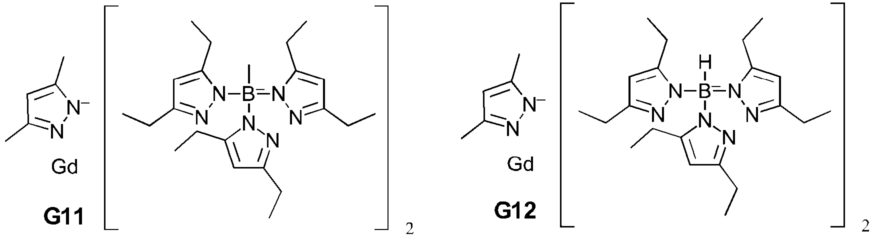

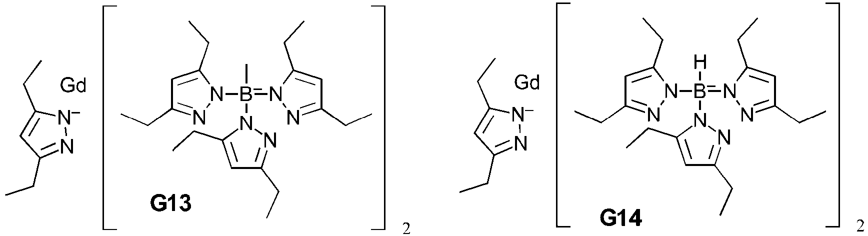

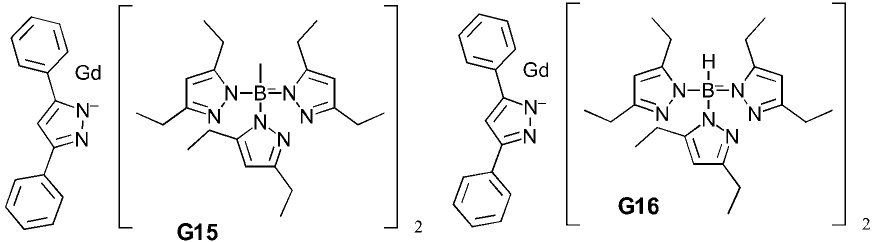

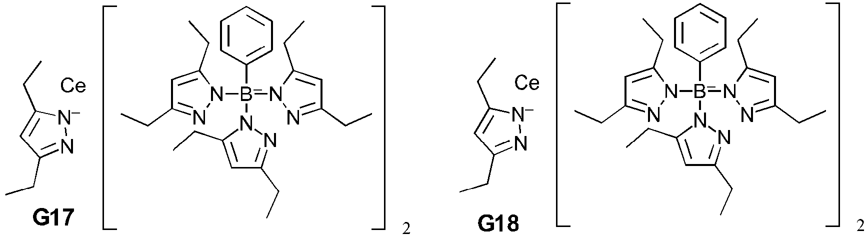

9. The electroluminescent device (100) of one of claims 1 to 8, with the organic layer (106) disposed between the first electrode and the second electrode (104, 108) additionally comprising at least one phosphorescent light emitting material which preferably emits substantially in the blue spectral region and/or preferably comprises a metal cation selected from Pt(II) and Ir(III).

10. The electroluminescent device (100) of one of claims 1 to 9, with the organic layer (106) disposed between the first electrode and the second electrode (104, 108) additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.

11. The electroluminescent device (100) of one of claims 1 to 10, with the organic layer (106) disposed between the first electrode and the second electrode (104, 108) comprising the metal organic coordination compound according to general formula (1-1) being configured as a hole transporting layer, wherein preferably the hole transporting layer is located adjacent to one of the electrodes, preferably the anode, or not being in contact with any of the electrodes, preferably as part of a charge generation layer.

12. The electroluminescent device (100) of claim 11, with the hole transport layer substantially only comprising the metal organic coordination compound of general formula (1-1) or comprising the metal organic coordination compound of general formula (1-1) mixed with one or more additional materials, preferably at least one redox dopant capable of generating free holes.

13. A process for preparing the electroluminescent device (100) according to one of claims 1 to 12, wherein the metal organic coordination compound of general formula (1-1) is deposited from a gas phase, preferably using an evaporation and/or sublimation and/or carrier gas process, or is deposited from solution.

14. A metal organic coordination compound of general formula (1-1) as defined in one of claims 1 to 8.
